# EUROPÄISCHE PATENTSCHRIFT

(11) **EP 3 014 674 B1**
(45) Veröffentlichungstag und Bekanntmachung des Hinweises auf die Patenterteilung: **28.08.2019**
(21) Anmeldenummer: 14734425.3
(22) Anmeldetag: 19.06.2014
(51) Int. Cl.: H01L 51/46

(54) **ORGANISCHES, HALBLEITENDES BAUELEMENT**
ORGANIC SEMICONDUCTIVE COMPONENT
COMPOSANT SEMI-CONDUCTEUR ORGANIQUE

(30) Priorität: 25.06.2013 DE 102013106639
(43) Veröffentlichungstag der Anmeldung: 04.05.2016
(73) Patentinhaber: Heliatek GmbH, 01139 Dresden (DE)
(72) Erfinder: WEISS, Andre, 01139 Dresden (DE); HILDEBRANDT, Dirk, 89077 Ulm (DE); GERDES, Olga, 89077 Ulm (DE); MATTERSTEIG, Gunter, 89077 Ulm (DE)
(86) Internationale Anmeldenummer: PCT/EP2014/062955
(87) Internationale Veröffentlichungsnummer: WO 2014/206860

(56) Entgegenhaltungen:
- WO-A1-2012/132447
- JP-A- 2008 109 097
- US-A1- 2010 231 125
- LUNT RICHARD ET AL: "Transparent, near-infrared organic photovoltaic solar cells for window and energy-scavenging applications", APPLIED PHYSICS LETTERS, AMERICAN INSTITUTE OF PHYSICS, US, Bd. 98, Nr. 11, 17. März 2011 (2011-03-17) , Seiten 113305-113305, XP012139740, ISSN: 0003-6951, DOI: 10.1063/1.3567516

## Beschreibung

Die vorliegende Erfindung betrifft ein Bauelement der organischen Elektronik, welches mindestens eine organische Schicht zwischen zwei Elektroden umfasst, wobei die organische Schicht wenigsten eine Verbindung aus der Gruppe der vorgeschlagenen BODIPY umfasst.

Es wird davon ausgegangen, dass organische Halbleiter auf Basis von niedermolekularen oder polymeren Verbindungen zunehmende Anwendungen in vielen Bereichen der Elektroindustrie finden werden. Dabei kommen die Vorteile der organischen Chemie zu Gute, wie energieschonendere Verarbeitbarkeit, bessere Substratkompabilität und größere Variationsmöglichkeit. Beispiele für organische Elektronik sind neben allgemeinen Elektronikschaltungen OLED, OPV, Photodetektoren, OFET.

Materialien der organischen Elektronik werden meist in Dotanden und eigenständige Halbleiter eingeteilt. Dotanden verändern die elektrischen Eigenschaften einer Matrixschicht, wenn sie mit dieser zusammen aufgetragen werden (z.B. co-verdampft), müssen aber nicht selber Halbleiter sein. Die organischen Halbleitermaterialien sind dagegen alleine schon halbleitend. Organische Halbleiter können in einem elektronischen Bauelement verschiedene Funktionen erfüllen, wie z.B. Ladungstransport, Strahlungsabsorption oder Strahlungsemission, wobei ein oder mehrere Funktionen gleichzeitig erfüllt werden können.

Weiterhin bekannt sind auch Solarzellen mit organischen aktiven Schichten, welche flexibel ausgestaltet sind (Konarka - Power Plastic Series). Die organischen aktiven Schichten können dabei aus Polymeren (z.B. US7825326 B2) oder kleinen Molekülen (z.B. EP 2385556 A1) aufgebaut sein. Während Polymere sich dadurch auszeichnen, dass diese nicht verdampfbar und daher nur aus Lösungen aufgebracht werden können, sind kleine Moleküle verdampfbar.

Der Vorteil solcher Bauelemente auf organischer Basis gegenüber den konventionellen Bauelementen auf anorganischer Basis (Halbleiter wie Silizium, Galliumarsenid) sind die teilweise extrem hohen optischen Absorptionskoeffizienten (bis zu 2x10⁵ cm-1), so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie.

Organische Solarzellen bestehen aus einer Folge dünner Schichten (die typischerweise jeweils 1nm bis 1µm dick sind) aus organischen Materialien, welche bevorzugt im Vakuum aufgedampft oder aus einer Lösung aufgeschleudert werden. Die elektrische Kontaktierung kann durch Metallschichten, transparente leitfähige Oxide (TCOs) und/oder transparente leitfähige Polymere (PEDOT-PSS, PANI) erfolgen.

Eine Solarzelle wandelt Lichtenergie in elektrische Energie um. In diesem Sinne wird der Begriff "photoaktiv" als Umwandlung von Lichtenergie in elektrische Energie verstanden. Im Gegensatz zu anorganischen Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluss beitragen.

In Mehrfachsolarzellen sind die einzelnen, gestapelten Zellen meist in Serie geschaltet, so dass die Zelle, die den geringsten Strom produziert, das ganze System limitiert. Um das volle Sonnenspektrum auszunutzen zu können sind dagegen mehrere Verbindungen notwendig, die bei unterschiedlichen Wellenlängen absorbieren und energetisch kombinierbar sind.

Es sind derzeit, insbesondere für den Bereich nicht-polymerer Verbindungen, nur wenige IR-Absorber im Bereich von 650 - 1400 nm für den Einsatz in Organischer Optoelektronik bekannt. IR-Absorber sind von besonderem Interesse, da sie im nichtsichtbaren Bereich des Lichtes absorbieren und daher dem menschlichen Betrachter transparent erscheinen oder in Kombination mit farbigen Absorbern einen breiteren Bereich des Sonnenspektrums nutzen können.

Die WO 2006/111511 beschreibt Hexaarylen- und Pentaarylentetracarbonsäureediimide als Aktivkomponenten in der Photovoltaik. WO2007/116001 betrifft Rylentetracarbonsäurederivate und deren Verwendung als organische Halbleiter vom n-Typ zur Herstellung von organischen Feldeffekttransistoren und von Solarzellen. WO 2008/145172 betrifft substituierte Carboxyphthalocyanine und deren Verwendung als Aktivkomponente in der Photovoltaik.

Die EP 2 693 504 A1 offenbart den Aufbau von Dünnfilm-Solarzellen und untersucht den Zusammenhang von Löchertransportschichten in Abhängigkeit von Naphthalocyanine-Komplexen als Absorber. Die WO2007/126052 beschreibt fluoreszierende Verbindung auf Basis eines BODIPY-Grundgerüstes sowie eine Anwendung der beschriebenen Verbindungen als Fluoresenzfarbstoffe. Die US 2010 0231125 A1 beschreibt die Verwendung von BODIPYs in der lichtemittierenden Schicht einer OLED. Nicht beschrieben ist die Anwendung der beschriebenen BODIPYs als Bestandteil in Absorber- oder Transportschichten in halbleitenden oder optoelektronischen Bauelement.

JP 2008 109 097 A offenbart die Verwendung von BODIPYs in Solarzellen, wobei diese in Verbindung mit einem elektronen-Donormaterial aus einer Lösung aufgebracht werden.

Lunt, R.R. u.a.: Transparent, near infrared organic photovoltaic solar cells for window and energy-scavenging applications. Appl. Physics Letters 98, 113305, 2011. beschreibt die Verwendung von ClAlPc als im nahen IR-Bereich absorbierendes Material in einer transparenten organischen Solarzelle. Die aus dem Stand der Technik bekannten IR-Farbstoffe sind teilweise nicht zufriedenstellend. So ist zum Beispiel die Prozessierbarkeit nicht ausreichend, die thermische Stabilität für eine Verdampfung im Vakuum nicht gegeben, sie besitzen keine befriedigende Absorptionsstärke in dünnen Schichten (z.B. auf Grund ungeeigneter Vorzugsorientierung beim Schichtwachstum oder zu geringem molarem Extinktionskoeffizienten), eine zu geringe Fotostabilität ist vorhanden, sie verfügen nicht über ausreichende Transporteigenschaften für einen Nutzen der absorbierten Strahlung oder sie passen energetisch nicht in das Bauelement.

Die Aufgabe besteht also darin IR-Absorber bereitzustellen, die für den Einsatz in Organischer Elektronik genutzt werden können und die vorgenannten Nachteile überwinden.

Die Aufgabe wird gelöst durch eine Solarzelle nach Anspruch 1, sowie durch die Verwendungen der Verbindungen nach Anspruch 12. Besondere Ausführungsformen der Erfindungen sind in den Unteransprüchen angegeben.

Erfindungsgemäß umfasst eine Solarzelle zumindest eine Schicht in einem Schichtsystem eine Verbindung der allgemeinen Formel I oder II 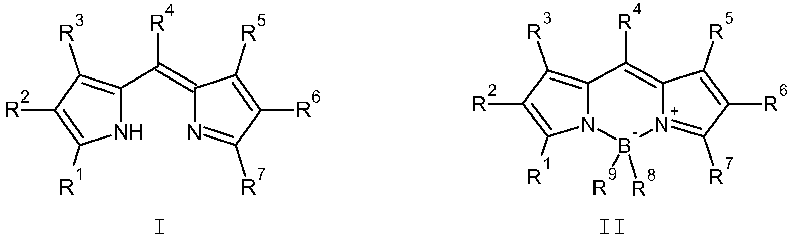 wobei
R1 und R2 und R6 und R7 jeweils zusammen ein heterocyclischen 5-Ring oder 6-Ring mit mindestens einem Heteroatom ausgesucht aus S, O, N oder P, oder einen homocyclischen, nicht weiter annelierten 6-Ring bilden,
R3, R4 und R5 unabhängig voneinander H oder ein Rest ausgesucht aus Aryl, Alkyl, fluoriertes oder teilfluoriertes Alkyl, ungesättigtes Alkyl und
R8 und R9 unabhängig voneinander ausgesucht sind aus Halogen, Alkyl, fluoriertes oder teilfluoriertes Alkyl, Alkenyl, Alkinyl, Alkoxy, Aryl oder Heteroaryl.

In einer Ausführungsform der Erfindung umfasst eine Solarzelle zumindest eine Schicht in einem Schichtsystem eine Verbindung der allgemeinen Formel II 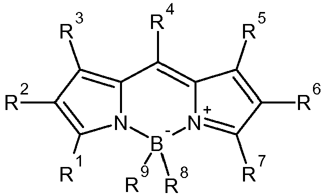
wobei R1 und R2 und R6 und R7 jeweils zusammen ein heterocyclischen 5-Ring oder 6-Ring mit mindestens einem Heteroatom ausgesucht aus S, O, N oder P, oder einen homocyclischen, nicht weiter annelierten 6-Ring bilden,
R3, R4 und R5 unabhängig voneinander H oder ein Rest ausgesucht aus Aryl, Alkyl, fluoriertes Alkyl, ungesättigtes Alkyl und R8 und R9 unabhängig voneinander ausgesucht sind aus Halogen, Alkyl, Alkenyl, Alkinyl, Alkoxy, Aryl oder Heteroaryl.

In einer Ausführungsform der Erfindung bilden in der Verbindung der allgemeinen Formel I oder II R1 und R2 und R6 und R7 jeweils zusammen ein heterocyclischen 5-Ring oder 6-Ring mit mindestens einem Heteroatom ausgesucht aus S, O, N oder P.

In einer Ausführungsform der Erfindung bilden sowohl R1 und R2 als auch R6 und R7 jeweils zusammen einen homocyclischen, nicht weiter annelierten 6-Ring. "Nicht weiter anneliert" bedeutet in diesem Zusammenhang, dass bis auf die Verbindungstellen zu R1 und R2 und/oder R6 und R7 kein weiteres Paar an Resten einen weiteren homocyclischen oder heterocyclischen Ring bildet.

Bevorzugt sind an den vier verbleibenden Bindungsstellen des homocyclischen Rings mindestens drei unsubstituiert.

In einer Ausführungsform der Erfindung ist R4 ausgesucht aus Aryl, Alkyl, fluoriertes oder teilfluoriertes Alkyl oder ungesättigtes Alkyl, bevorzugt ist R4 aber ein fluoriertes oder teilfluoriertes Alkyl.

In einer Ausführungsform der Erfindung ist die Verbindung der allgemeinen Formel I zwischen 300 und 1500 g/mol groß.

In einer Ausführungsform der Erfindung ist der von R1 und R2 und R6 und R7 gebildete heterocyclischen 5-Ring oder 6-Ring ausgesucht aus einer der folgenden Formeln. Für den Fall, dass sowohl R1 und R2, als auch R6 und R7 einen Ring bilden, können beide Ringe gleich oder verschieden sein.

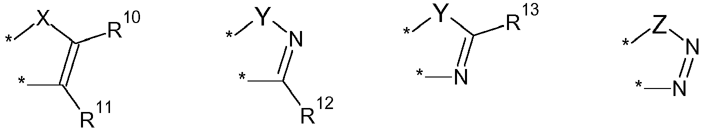

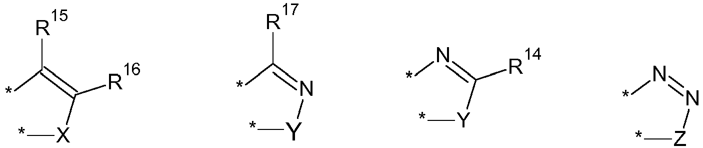

Die mit * gekennzeichneten Teile der obigen Formeln stellen die Bindungsstelle zu R1, R2, R6 oder R7 von allgemeiner Formel I oder II dar. X, Y und Z sind unabhängig voneinander ausgewählt aus O, S, Se oder N-R18 mit R18 ausgewählt aus H oder Alkyl, und R10 bis R17 sind unabhängig voneinander ausgesucht aus H, Alkyl, Alkinyl, Alkenyl OAlkyl, SAlkyl, Aryl, Heteroaryl, halogeniertes Alkyl, cyaniertes Alkyl.

In einer Ausführungsform der Erfindung ist der von R1 und R2 und R6 und R7 gebildete homocyclischen, nicht weiter annelierten 6-Ring ausgesucht aus einer Verbindung der folgenden Formel. Beide Ringe können gleich oder verschieden sein.

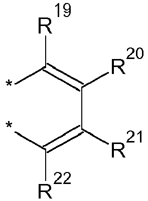

Die mit * gekennzeichneten Teile der obigen Formeln stellen die Bindungsstelle zu R1, R2, R6 oder R7 von allgemeiner Formel I oder II dar. R19 bis R22 sind unabhängig voneinander ausgesucht aus H, Alkyl, Alkinyl, Alkenyl OAlkyl, SAlkyl, Aryl, Heteroaryl, halogeniertes Alkyl, cyaniertes Alkyl.

In einer Ausführungsform der Erfindung besitzt ein Aryl oder Arylrest an R10 bis R17 oder R19 bis R22 einen weiteren Rest der den Donorcharakter des Aryl oder Heteraryl erhöht, bevorzugt Alkyl, OAlkyl, N(Alkyl)₂ oder NCycloalkyl

Bevorzugte erfindungsgemäße Verbindungen der allgemeinen Formel (I) oder (II) sind nachfolgend dargestellt:

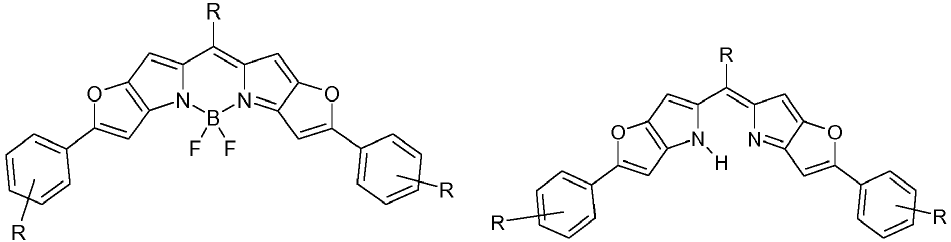

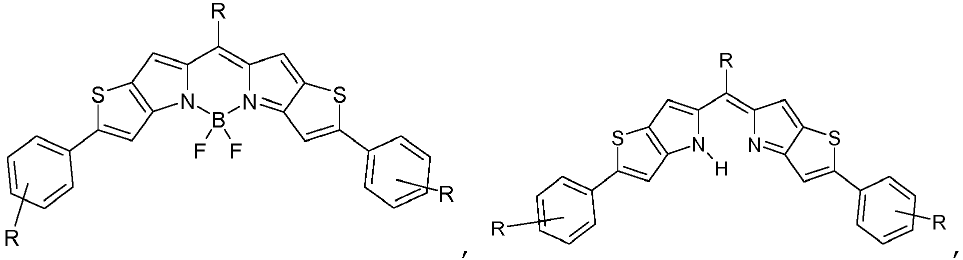

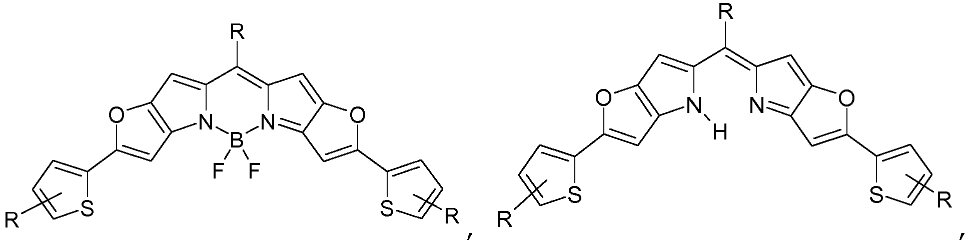

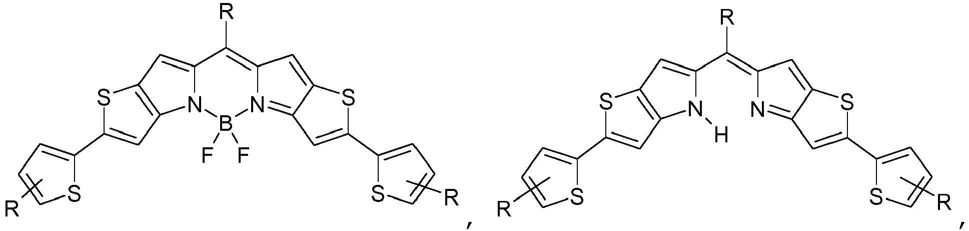

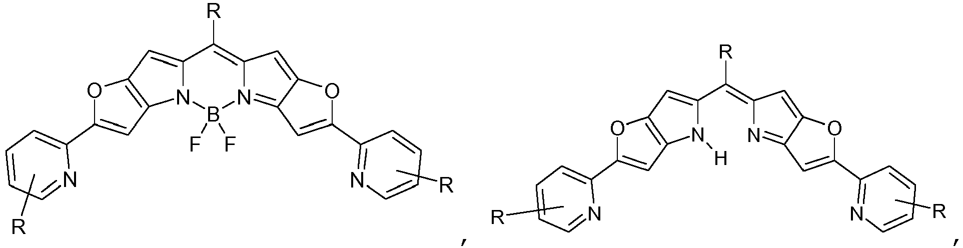

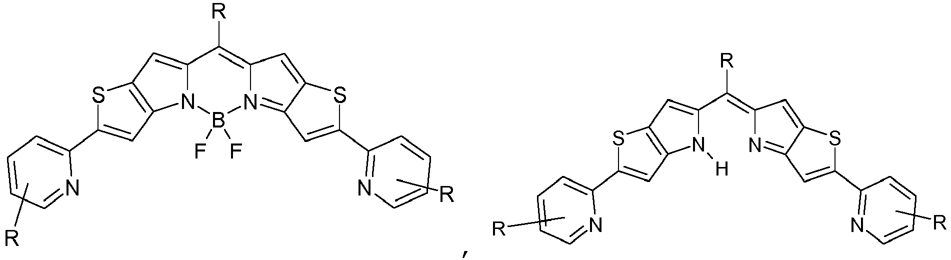

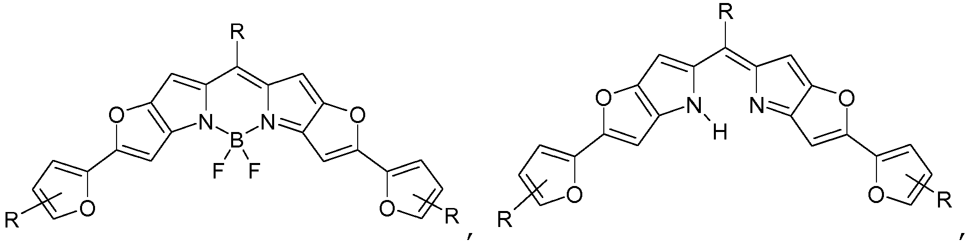

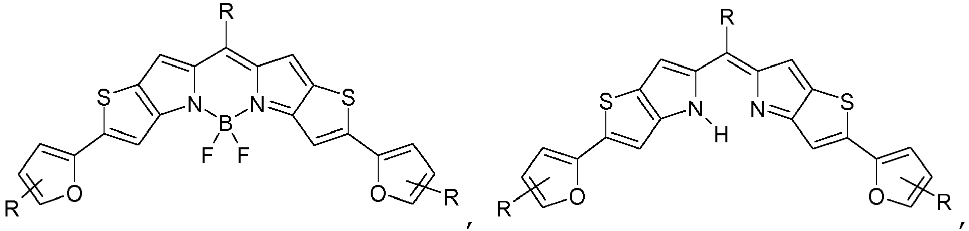

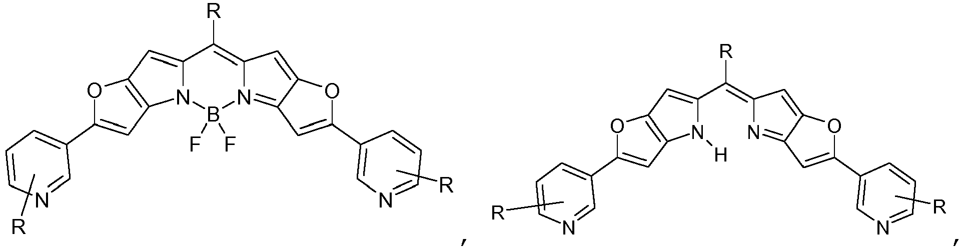

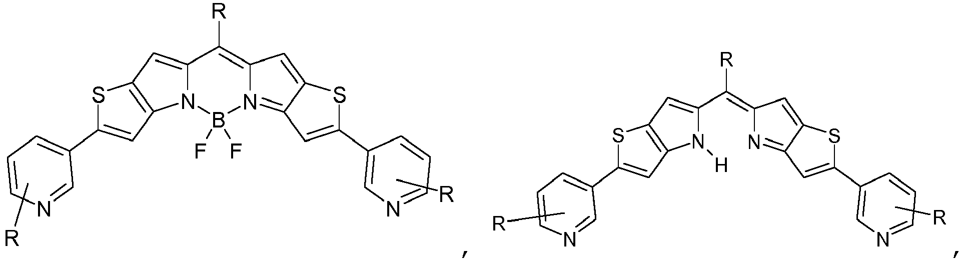

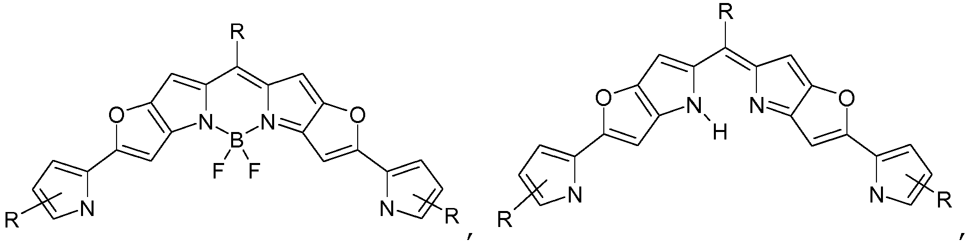

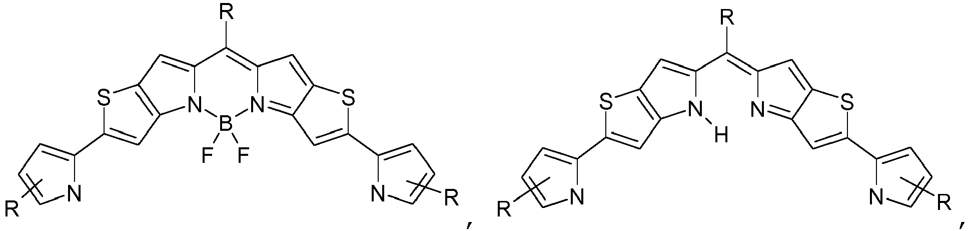

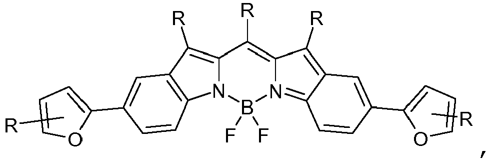

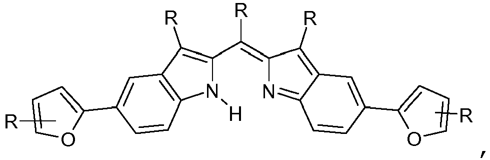

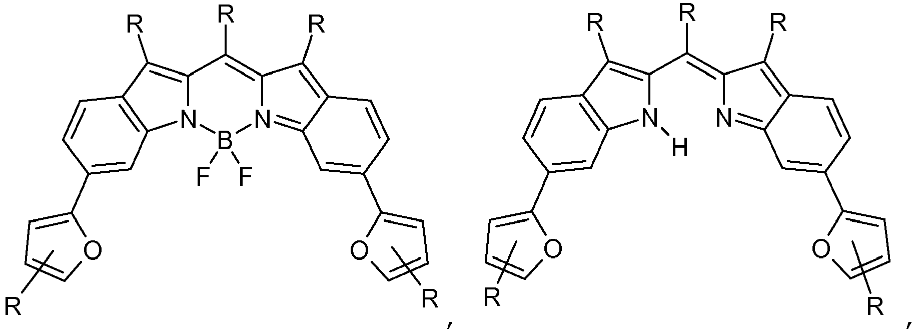

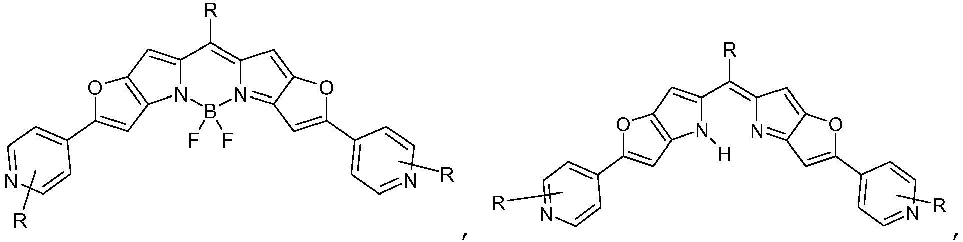

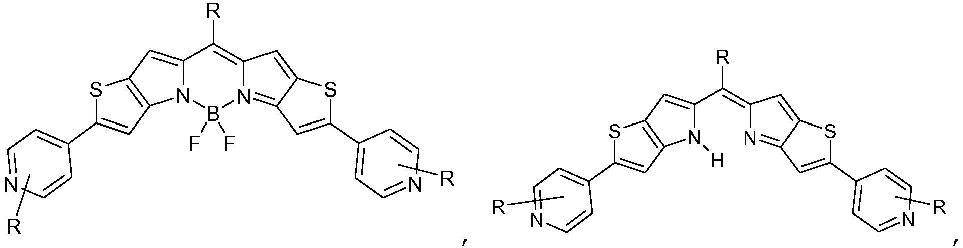

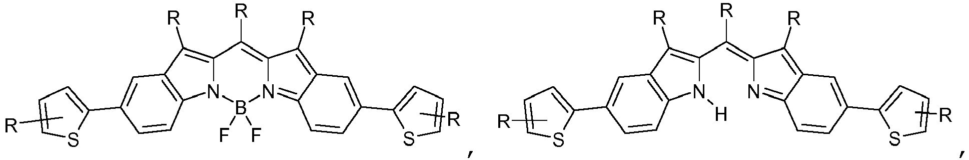

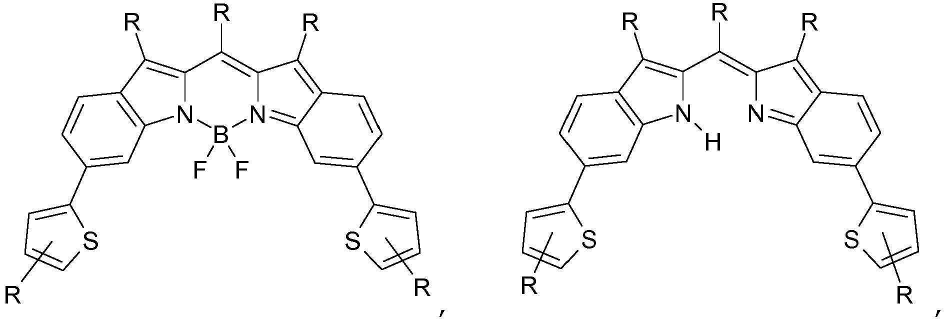

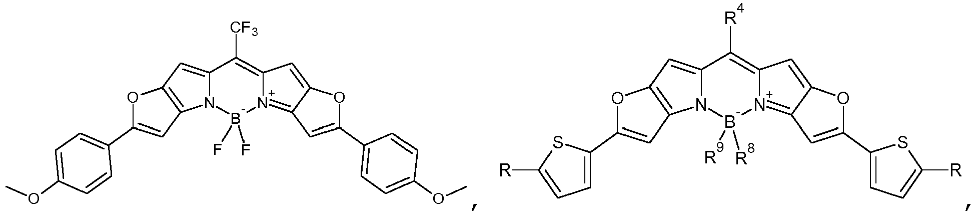

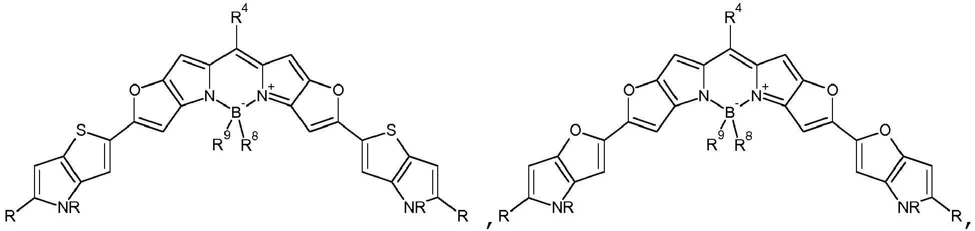

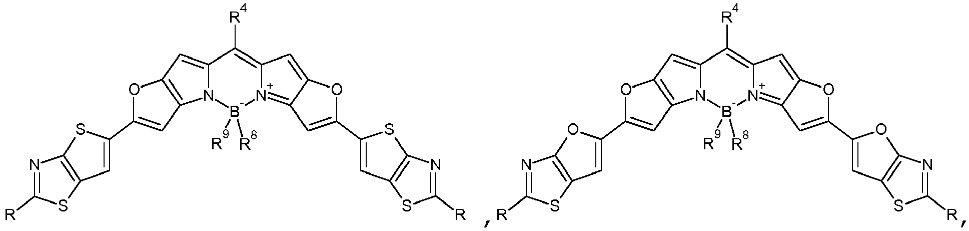

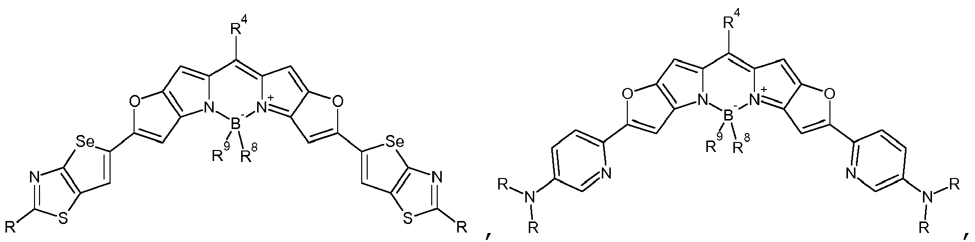

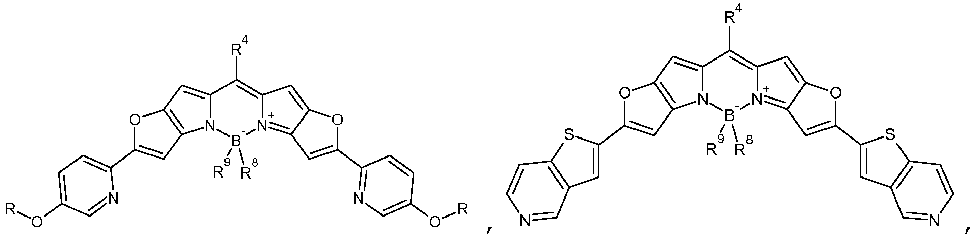

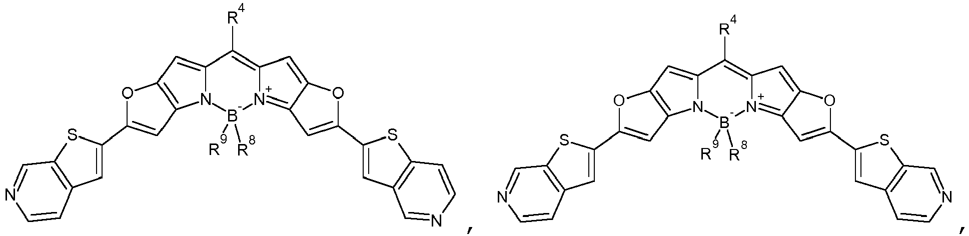

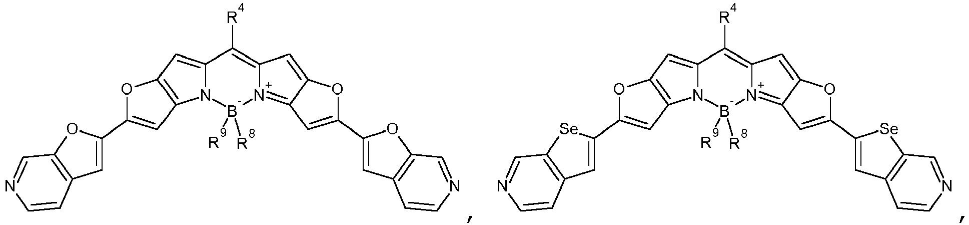

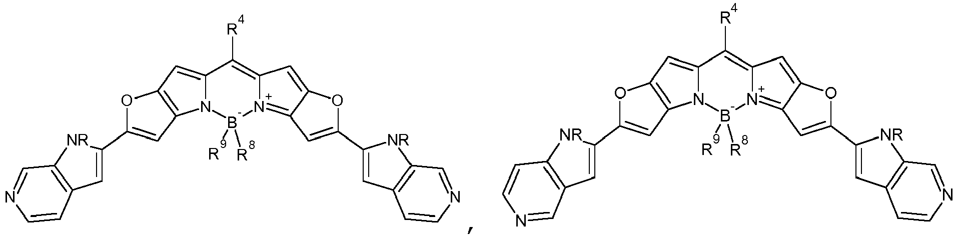

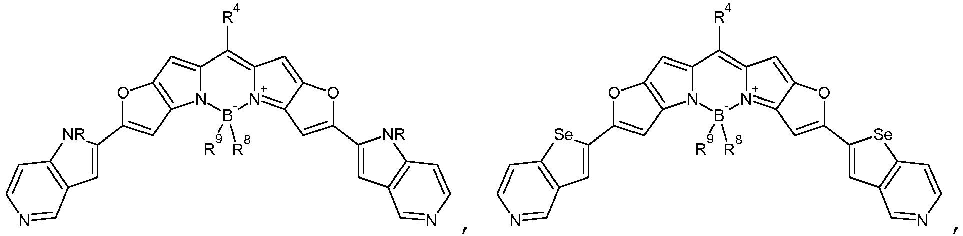

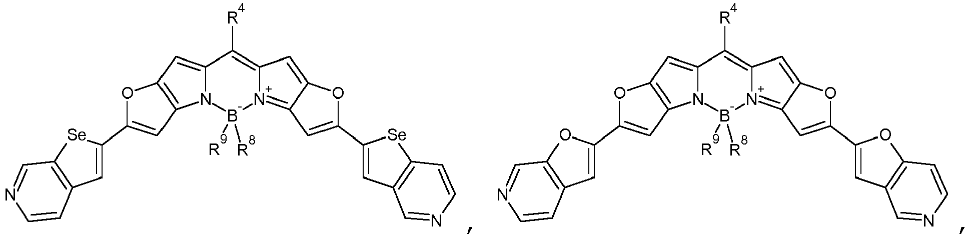

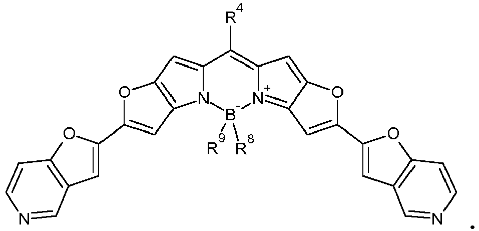

Die erfindungsgemäßen Verbindungen der allgemeinen Formel I oder II absorbieren rotes und nah-infrarotes Licht in einem Wellenlängenbereich von 600 bis 900 nm. Erstaunlicherweise wurde gefunden, dass sie darüber hinaus über ausreichende Transporteigenschaften besitzen um in halbleitenden Bauelemente verwendet werden zu können. So lassen sie sich durch leichte Variationen energetisch an das Schichtsystem des Bauelements anpassen. Damit lassen sich für das menschliche Auge weitgehend transparent erscheinende halbleitende Bauelemente und in Kombination mit anderen Absorbermaterialien Tandemsolarzellen mit verbesserter Effizienz herstellen.

In der Regel sind die Verbindungen der allgemeinen Formel I oder II thermisch bis über 300°C stabil und lassen sich zersetzungsfrei durch thermisches Verdampfen im Vakuum zu Schichten verarbeiten. Zusätzlich kann mit den erfindungsgemäßen Verbindungen die absorbierte Energie an einem Heteroübergang zu Molekülen mit Akzeptor-Charakter (z.B. Fulleren C60) in freie Ladungsträgerpaare und letztlich in elektrische Energie überführt und genutzt werden.

Erfindungsgemäß ist das halbleitende Bauelement eine Solarzelle. Unter Optoelektronik werden im weitesten Sinne Bauelemente verstanden, die einfallendes Licht in elektrische Energie bzw. elektrische Strom- bzw. Spannungssignale oder elektrische Energie in Lichtemission umwandeln können.

Eine Verbindung nach der allgemeinen Formel I oder II wird als absorbierendes Material in einem Lichtabsorber-Schichtsystem eingesetzt.

Die Verbindung nach allgemeiner Formel I oder II wird als Donor in einem Donor-Akzeptor-Heteroübergang eingesetzt.

Der photoaktive Bereich enthält wenigstens ein organisches Donormaterial in Kontakt mit wenigstens einem organischen Akzeptormaterial, wobei das Donormaterial und das Akzeptormaterial einen Donor-Akzeptor-Heteroübergang ausbilden und wobei der photoaktive Bereich wenigstens eine Verbindung der Formel I oder II aufweist.

Geeignete Akzeptormaterialien sind vorzugsweise ausgewählt aus der Gruppe der Fullerene und Fullerenderivate, der polycyclische aromatische Kohlenwasserstoffen und deren Derivaten, insbesondere Naphthalin und dessen Derivate, Rylene, insbesondere Perylen, Terrylen und Quaterrylen, und deren Derivate, Azene, insbesondere Anthrazen, Tetrazen, in besondere Rubren, Pentazen und deren Derivate, Pyren und dessen Derivat, der Chinone, Chinondimethane und deren Derivaten, der Phthalocyaninen und Subphthalocyanine und deren Derivaten, der Porphyrinen, Tetraazoporphyrinen, Tetrabenzoporphyrinen und deren Derivaten, der Thiophene, oligo-Thiophene, kondensierte/anellierte Thiophene, wie Thienoth ophen und Bithienothiophen, und deren Derivate, der Thiadiazole und deren Derivate, der Carbazole und Triarylamine und deren Derivate, der Indanthrone, Violanthrone und Flavanthone und deren Derivate.

In einer Ausführungsform der Erfindung enthält die Solarzelle ein oder mehrere Transportschichten, die dotiert, teilweise dotiert oder undotiert sein können. Unter Transportschichtsystem werden dabei Schichten aus ein oder mehreren Lagen verstanden, die Ladungsträger einer Art transportieren und vorzugsweise selber elektromagnetische Strahlung nur in einem Bereich von < 450nm absorbieren.

Unter Dotierung wird verstanden, wenn die Beimischung eines Dotanden zu einer Erhöhung der Dichte freier Ladungsträger, Elektronen für n-Dotierung und Löcher für p-Dotierung, führt.

Dotanden sind dabei Verbindungen die die elektrischen Eigenschaften des Matrixmaterials verändern ohne notwendigerweise selber halbleitenden zu sein. Im Allgemeinen liegen Dotierkonzentrationen zwischen 1% und 30%.

Eine in der Literatur bereits vorgeschlagene Realisierungsmöglichkeit einer organischen Solarzelle besteht in einer pin -Diode mit folgendem Schichtaufbau:
0. Träger, Substrat,
1. Grundkontakt, meist transparent,
2. p- Schicht(en),
3. i- Schicht(en)
4. n- Schicht(en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. In diesem Sinne sind derartige Schichten primär als Transportschichten zu verstehen. Die Bezeichnung i-Schicht bezeichnet demgegenüber eine undotierte Schicht (intrinsische Schicht). Eine oder mehrere i-Schicht(en) können hierbei Schichten sowohl aus einem Material, als auch eine Mischung aus zwei oder mehr Materialien (sogenannte interpenetrierende Netzwerke) bestehen.

In einer Ausführungsform der Erfindung besteht die n-Schicht und/oder die p-Schicht aus einer Folge von dotierten oder undotierten Schichten.

In einer Ausführungsform der Erfindung ist die i-Schicht des halbleitenden Bauelements als Mischschicht ausgebildet. Dies kann beispielsweise durch Co-Verdampfen zweier oder mehrerer Materialien erreicht werden. In einem Heteroübergang fungiert das eine Material des Schichtsystems als Donor und das andere Material als Akzeptor für Elektronen. An der Grenzschicht werden die erzeugten Excitonen getrennt. Der Vorteil einer Mischschicht gegenüber einem flachen Heteroübergang, bei dem Donor und Akzeptor als zwei aneinander grenzende Schichten vorliegen, ist, dass die Excitonen nur einen geringen Weg bis zur nächsten Grenzschicht zurücklegen müssen.

In einer Ausführungsform der Erfindung ist das Absorberschichtsystem der Solarzelle als Mischsicht mit angrenzender Einzelschicht ausgebildet.

In einer Ausführungsform der Erfindung ist zwischen dem Grundkontakt und der p-Schicht und/oder zwischen der p-Schicht und der i-Schicht eine n-Schicht angeordnet.

In einer Ausführungsform der Erfindung ist zwischen dem Deckkontakt und der n-Schicht und/oder zwischen der n-Schicht und der i-Schicht eine p-Schicht angeordnet.

In einer Ausführungsform der Erfindung ist die Schichtfolge invertiert und es handelt sich um eine nip.

In einer Ausführungsform der Erfindung werden eine oder mehrere Transportschichten als so genannte Spacerschichten in ihrer Dicke so gewählt, dass die absorbierenden i-Schichten an den Ort des optischen Maximums der einfallenden Strahlung positioniert werden können. Damit kann die Effizienz des Bauelements erhöht werden.

In einer Ausführungsform der Erfindung sind zwischen den einzelnen Zellen eines Tandem- oder Mehrfachzellen-Bauelements ein oder mehrere Konversionskontakte angeordnet.

In einer Ausführungsform der Erfindung ist das erfindungsgemäße Bauelement ein Tandem- oder Mehrfachzelle, wobei zwei oder mehr Zellen gestapelt und in Serie verschaltet sind. Dabei sind die i-Schichten der einzelnen Zellen aus gleichen oder unterschiedlichen Materialien oder Materialmischungen aufgebaut.

In einer Ausführungsform der Erfindung ist die Solarzelle auf einem flexiblen Substrat aufgebracht.

Unter einem flexiblen Substrat wird im Sinne der vorliegenden Erfindung ein Substrat verstanden, welches eine Verformbarkeit infolge äußerer Krafteinwirkung gewährleistet. Dadurch sind solche flexiblen Substrate zur Anordnung auf gekrümmten Oberflächen geeignet. Flexible Substrate sind beispielsweise Folien oder Metallbänder.

In einer weiteren Ausführungsform der Erfindung ist die Elektrode, welche auf dem Substrat angeordnet ist opak oder transparent ausgeführt.

In einer weiteren Ausführungsform der Erfindung sind beide Elektroden transparent.

Die Verbindungen der allgemeinen Formel I oder II können wie in WO2007/126052 beschrieben hergestellt werden.

Die Herstellung der einzelnen Schichten eines erfindungsgemäßen Bauelements kann durch Verdampfen im Vakuum, mit oder ohne Trägergas oder prozessieren einer Lösung oder Suspension, wie zum Beispiel beim Coaten oder Drucken geschehen. Einzelne Schichten können ebenso durch Sputtern aufgetragen werden. Dies ist vor allem für den Grundkontakt möglich. Vorteilhaft ist die Herstellung der Schichten durch Verdampfen im Vakuum, wobei das Trägersubstrat erwärmt sein kann. Erstaunlicherweise wurde gefunden, dass die erfindungsgemäßen Verbindungen nach Formel I oder II bei Erhöhen der Substrattemperatur auf bis zu über 100°C während des Schichtwachstums zu gut funktionierenden halbleitenden Bauelementen mit stark absorbierenden Absorberschichten verarbeitet werden können. Das heißt, dass sie nicht zu übermäßiger Kristallisation und damit zur Ausbildung von zu rauhen Schichten neigen. Ebenso wenig wird beim Wachstum auf erwärmtem Substrat eine starke Abnahme der Absorption durch ungeeignete Vorzugsorientierung (Moleküle, die mit ihrem Übergangsdipolmoment nahezu senkrecht auf dem Substrat stehen) beobachtet. Trotzdem wird bei Erhöhung der Substrattemperatur während des Schichtwachstums, insbesondere für photoaktive Mischschichten mit Fulleren C₆₀, eine Verbesserung der Transporteigenschaften durch verbesserte Ordnung und damit eine Erhöhung des Füllfaktors von Solarzellen beobachtet.

Eine ungünstige Vorzugsorientierung mit bevorzugt "stehenden" molekularen Übergangdipolen wird für Oligomere wie Oligothiophene, terminal alkylierte Oligothiophene oder Oligoaryle häufig beobachtet, und solche Verbindungen sind damit ungeeignet für den Einsatz in Solarzellen, da sie nur schwach mit dem einfallenden Licht wechselwirken.

Die Ausführungsformen können miteinander kombiniert werden.

Nachfolgend soll die Erfindung anhand einiger Ausführungsbeispiele und Figuren eingehend erläutert werden. Die Ausführungsbeispiele sollen dabei die Erfindung beschreiben ohne diese zu beschränken. Es zeigen in
Fig. 1 eine schematische Darstellung eines halbleitenden Bauelements,
Fig. 2 eine grafische Darstellung eines Absorptionsspektrums einer erfindungsgemäßen Verbindung der allgemeinen Formel II,
Fig. 3 eine grafische Darstellung einer spektralen externen Quantenausbeute einer erfindungsgemäßen Verbindung der allgemeinen Formel II in einem halbleitenden Bauelement und
Fig. 4 eine grafische Darstellung des Füllfaktors und der Effizienz eine MIP-Bauelements bei unterschiedlichen Substrattemperaturen.

### Ausführungsbeispiel Verbindung (1)

In einem Ausführungsbeispiel wird ein MIP Bauelement bestehend aus einer Probe auf Glas mit transparentem Grundkontakt ITO (M), einer Schicht Fulleren C₆₀ (I), einer 1:1 Mischschicht von Verbindung 1 mit Fulleren C₆₀ (I), einer p-dotierten Löchertransportschicht aus Di-NPB und NDP9 und einem Deckkontakt aus Gold hergestellt, wobei die Mischschicht aus Verbindung 1 und C₆₀ bei einer Substrattemperatur von 110°C abgeschieden wurde.

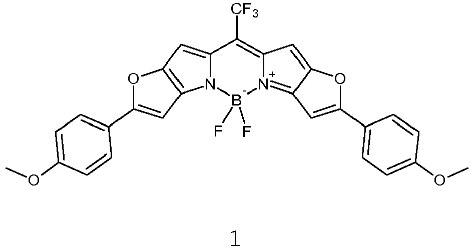

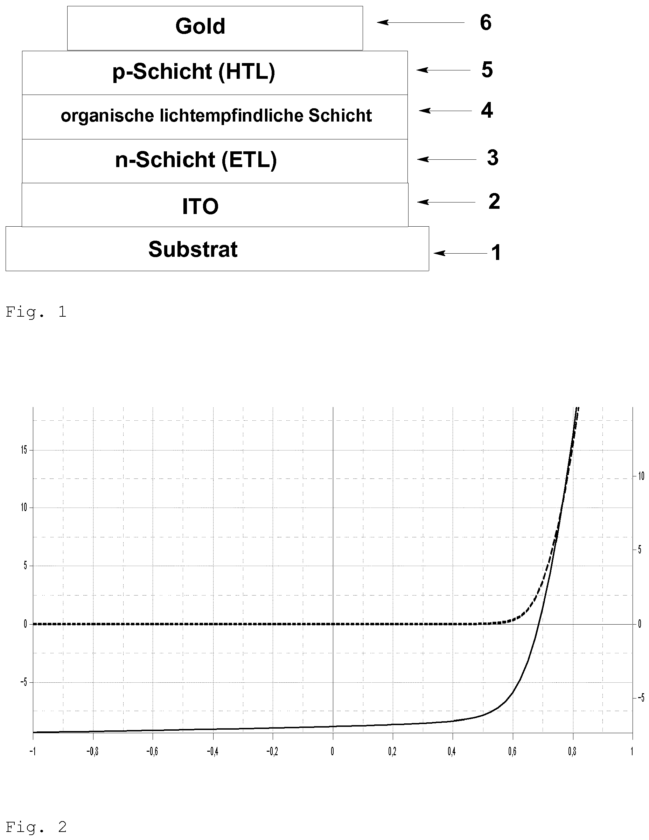

In Figur 2 ist die Strom-Spannungskurve dieses Bauelements gezeigt. Die wichtigsten Kennzahlen sind der Füllfaktor FF mit 66 %, die Leerlaufspannung U_{OC} mit 0,69 V und der Kurzschlussstrom j_{SC} mit 9,2 mA und zeigen eine gut funktionierende Solarzelle.

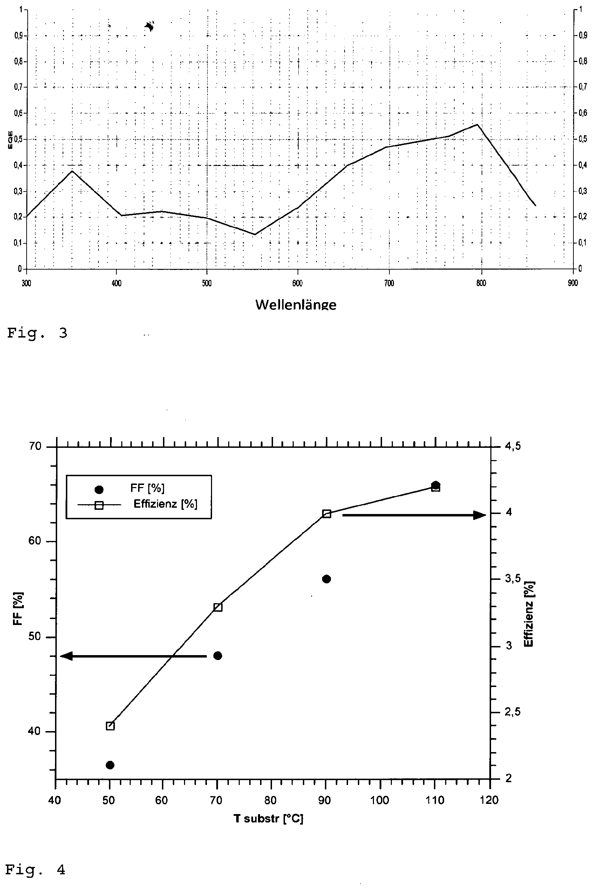

In Figur 3 ist das Schema der spektralen externen Quantenausbeute zu sehen, welche als Anzahl abgeführter Elektronen pro einfallendes Photon definiert ist, zu sehen. Sie zeigt deutlich, dass sowohl C₆₀ als auch Verbindung 1 photoaktiv sind.

### Ausführungsbeispiel 2

Je eine MIP wie in Beispiel 1 beschrieben wurde bei unterschiedlichen Substrattemperaturen, 50°C, 70°C, 90°C und 110°C hergestellt. Aus der grafischen Darstellung in Figur 4 ist zu sehen, dass der Füllfaktor und die Effizienz mit steigender Substrattemperatur ebenfalls ansteigen.

## Patentansprüche

1. Solarzelle, umfassend ein Schichtsystem, wobei zumindest eine Schicht des Schichtsystems eine Licht absorbierende Schicht ist, wobei diese Licht absorbierende Schicht eine Verbindung der allgemeinen Formel I oder II 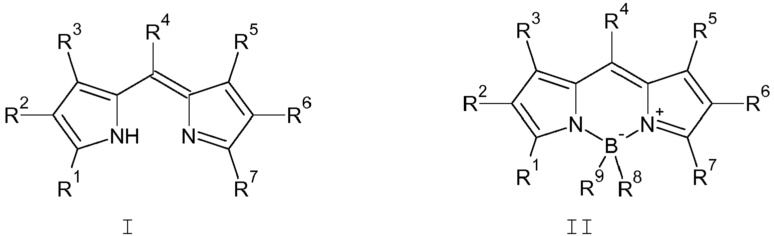 umfasst wobei
• R3, R4 und R5 unabhängig voneinander H oder ein Rest ausgesucht aus Aryl, Alkyl, fluoriertes oder teilfluoriertes Alkyl, ungesättigtes Alkyl
• R8 und R9 unabhängig voneinander ausgesucht sind aus Halogen, Alkyl, fluoriertes oder teilfluoriertes Alkyl, Alkenyl, Alkinyl, Alkoxy, Aryl oder Heteroaryl,
**dadurch gekennzeichnet, dass**
• R1 und R2, und R6 und R7 jeweils zusammen einen heterocyclischen 5-Ring oder 6-Ring mit mindestens einem Heteroatom ausgesucht aus S, O, N oder P, bilden, oder
R1 und R2, und R6 und R7 jeweils einen homocyclischen, nicht weiter anellierten 6-Ring bilden, wobei bevorzugt mindestens drei der vier verbleibenden Bindungsstellen des homocyclischen Rings unsubstituiert bleiben und die Verbindung gemäß Formel I oder II ein Donor in einem Donor-Akzeptor-Heteroübergang ist.

2. Solarzelle nach Anspruch 1, wobei der von R1 und R2; und R6 und R7 gebildete heterocyclische 5-Ring unabhängig ausgesucht ist aus den folgenden Formeln 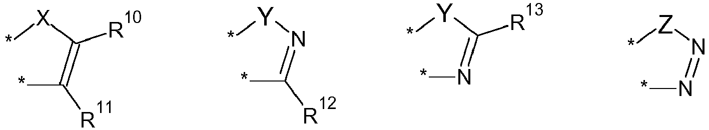 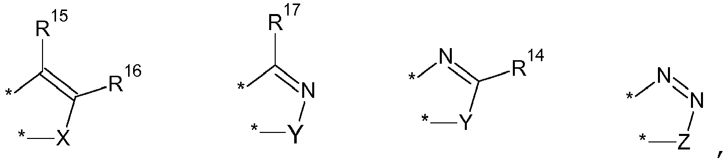 wobei
• die mit * gekennzeichneten Teile der obigen Formeln die Bindungsstelle zu R1, R2, R6 oder R7 in der allgemeinen Formel I oder II darstellen, und
• X, Y und Z unabhängig voneinander ausgewählt sind aus O, S, Se oder N-R18 mit R18 ausgewählt aus H oder Alkyl, und
• R10 bis R17 unabhängig voneinander ausgesucht sind aus H, Alkyl, Alkinyl, Alkenyl OAlkyl, SAlkyl, Aryl, Heteroaryl, halogeniertes Alkyl, cyaniertes Alkyl.

3. Solarzelle nach Anspruch 1, wobei der von R1 und R2, und R6 und R7 gebildete homocyclische, nicht weiter annelierte 6-Ring unabhängig ausgesucht ist aus der Formel 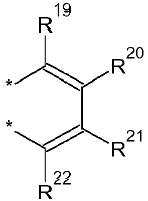 wobei
• die mit * gekennzeichneten Teile der obigen Formel die Bindungsstelle zu R1, R2, R6 oder R7 in der allgemeinen Formel I oder II darstellen, und
• R19 bis R22 unabhängig voneinander ausgesucht sind aus H, Alkyl, Alkinyl, Alkenyl OAlkyl, SAlkyl, Aryl, Heteroaryl, halogeniertes Alkyl, cyaniertes Alkyl.

4. Solarzelle nach Anspruch 2 oder 3, **dadurch gekennzeichnet, dass** das Aryl oder der Arylrest an R10 bis R17 oder R19 bis R22 einen weiteren Rest besitzt, der den Donor-Charakter des Aryls oder Heteroaryls erhöht, bevorzugt ist der Rest ausgewählt aus Alkyl, OAlkyl, N(Alkyl)₂ oder NCycloalkyl.

5. Solarzelle nach einem der vorhergehenden Ansprüche, wobei R4 ein Rest ausgesucht aus Aryl, Alkyl, fluoriertes oder teilfluoriertes Alkyl oder ungesättigtes Alkyl ist, bevorzugt ein fluoriertes oder teilfluoriertes Alkyl.

6. Solarzelle nach einem der vorhergehenden Ansprüche, wobei die Verbindungen ein Molargewicht von 300-1500 g/mol haben.

7. Solarzelle nach einem der vorhergehenden Ansprüche, wobei die Verbindung ausgewählt ist aus:

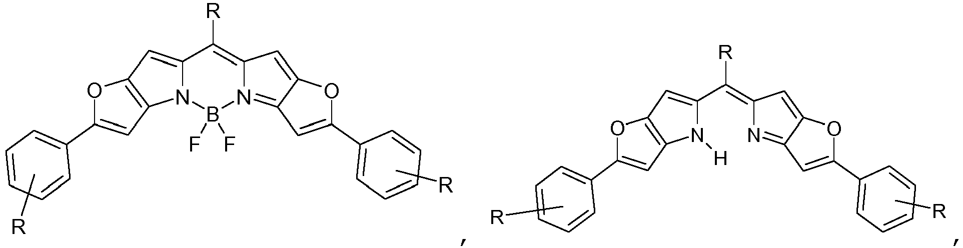

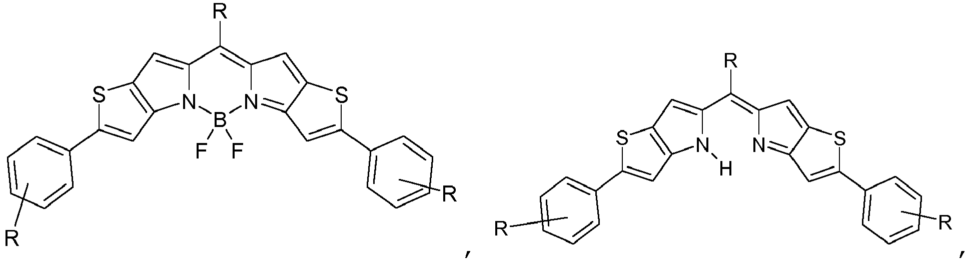

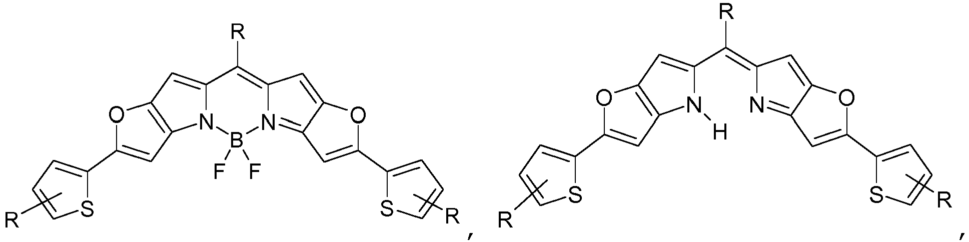

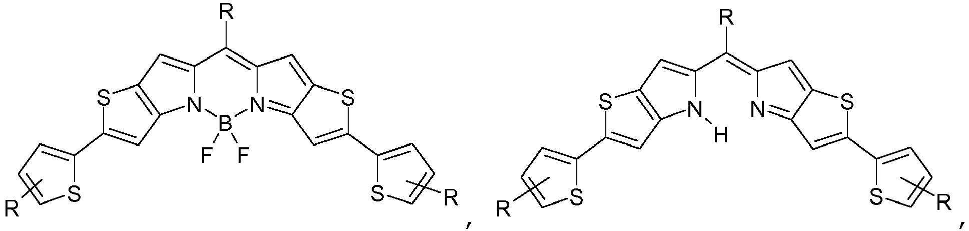

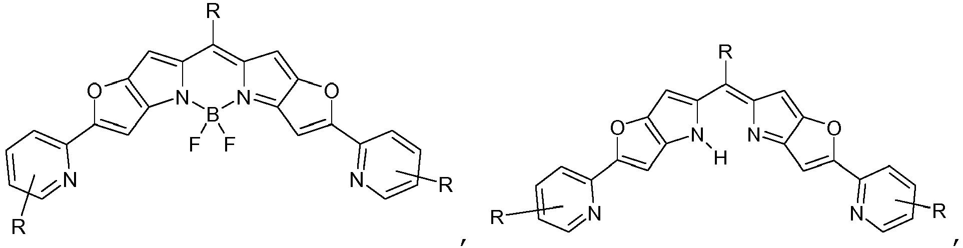

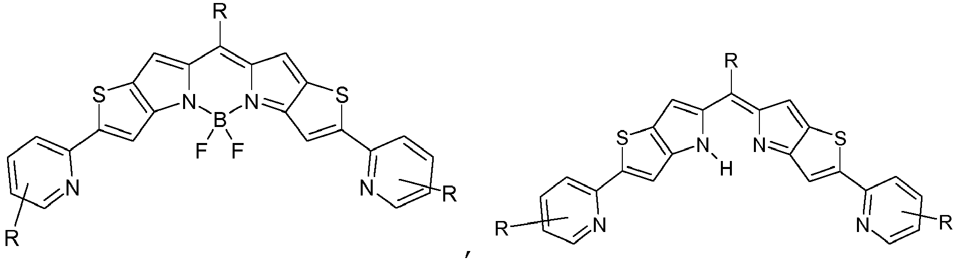

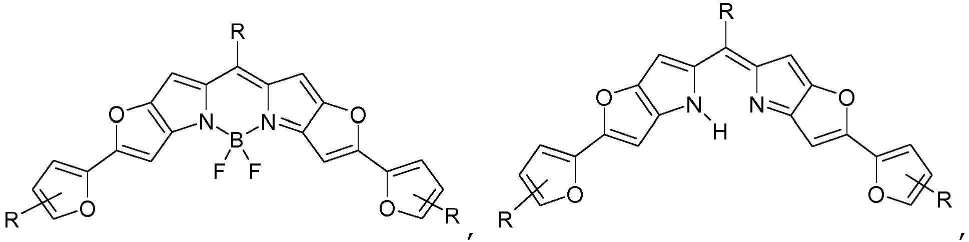

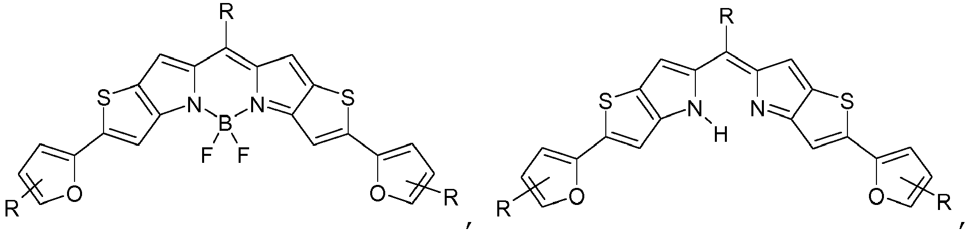

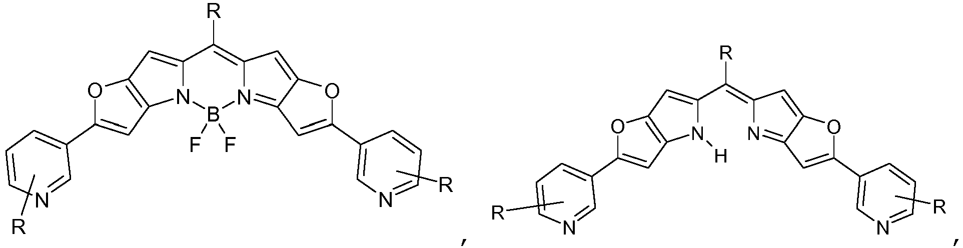

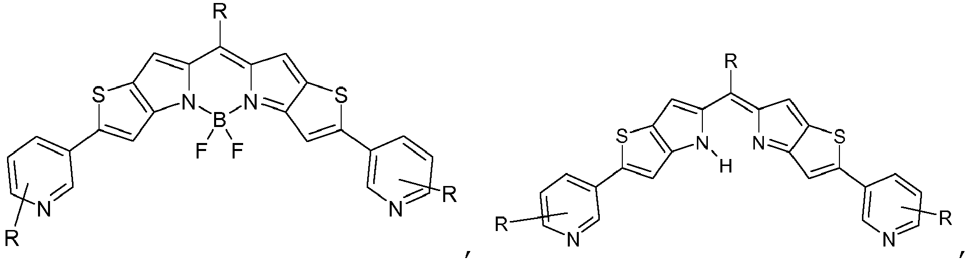

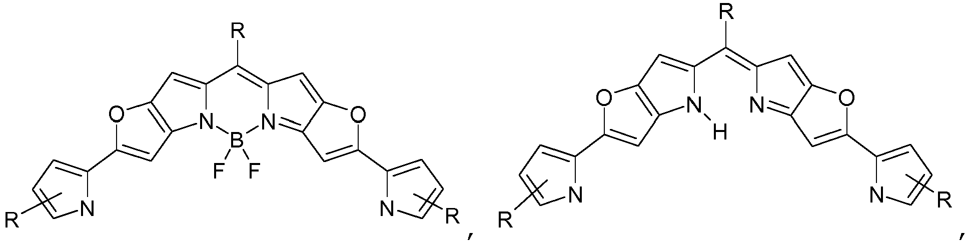

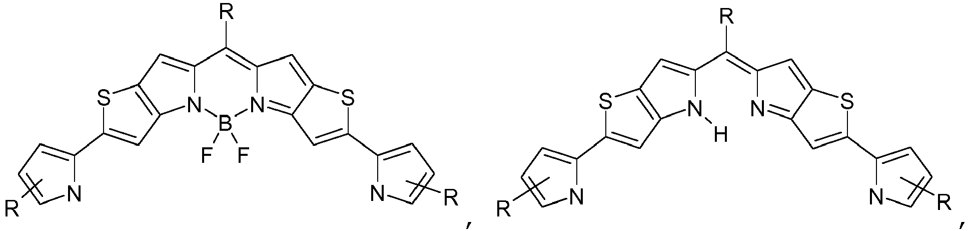

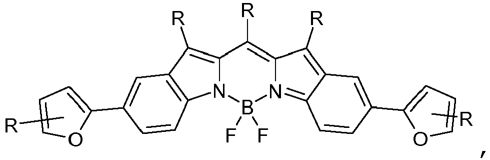

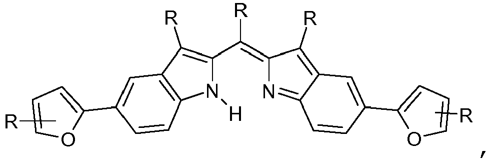

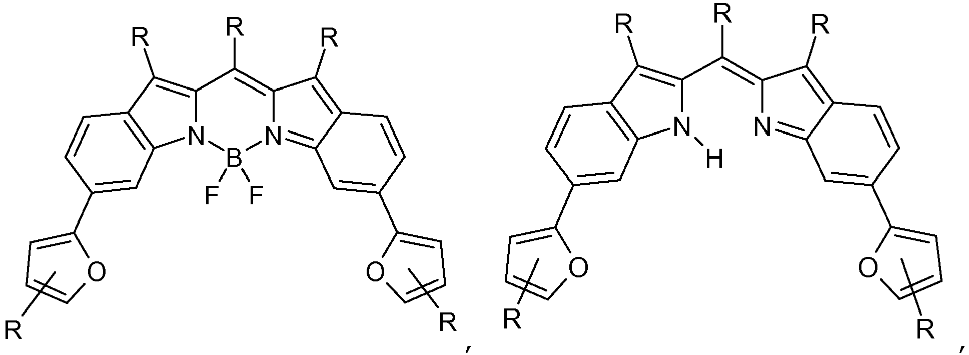

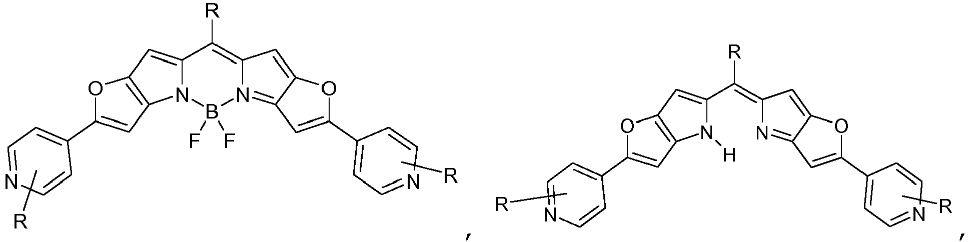

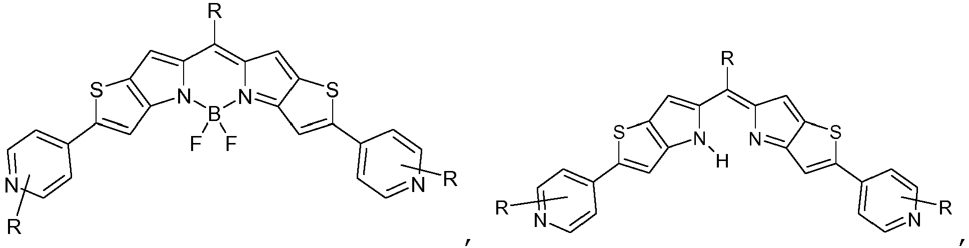

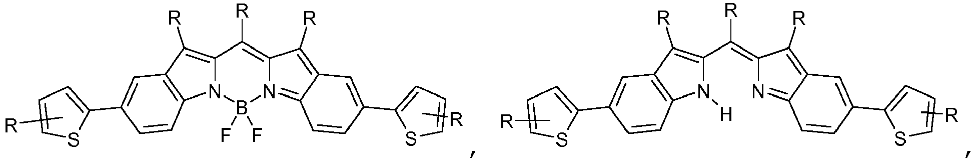

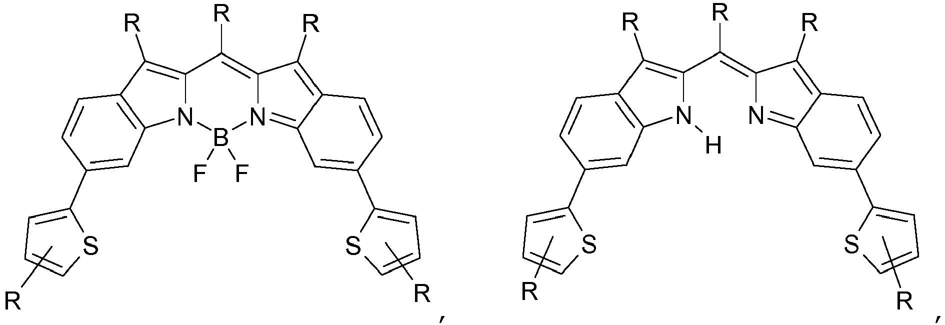

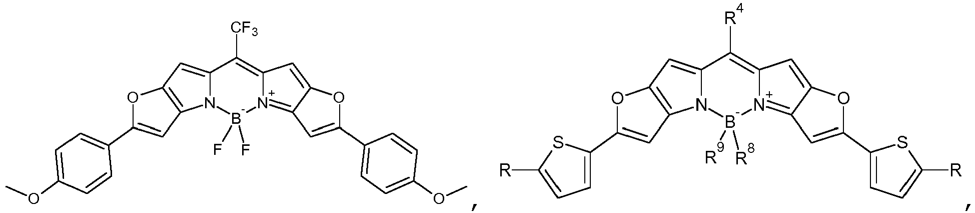

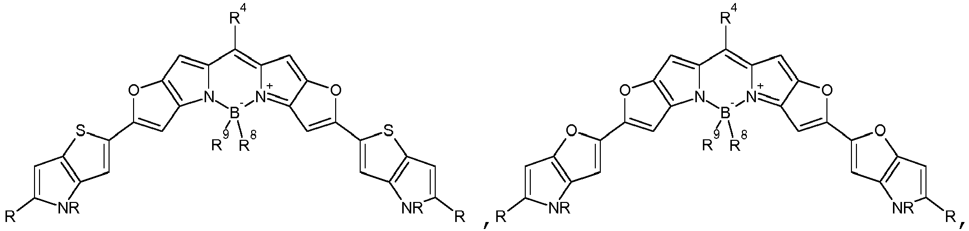

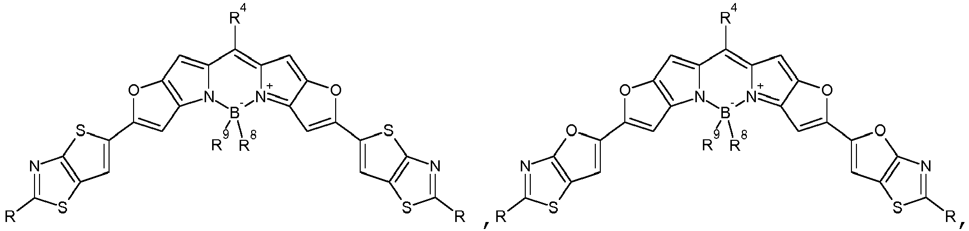

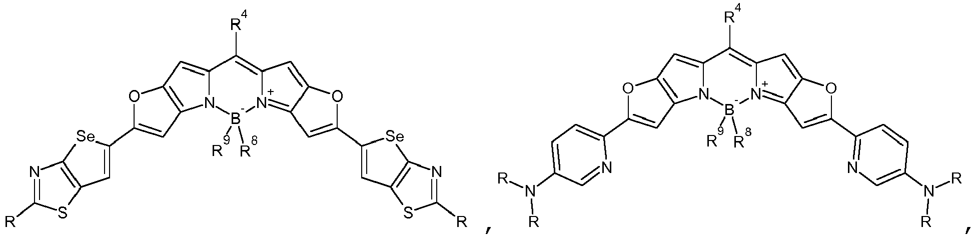

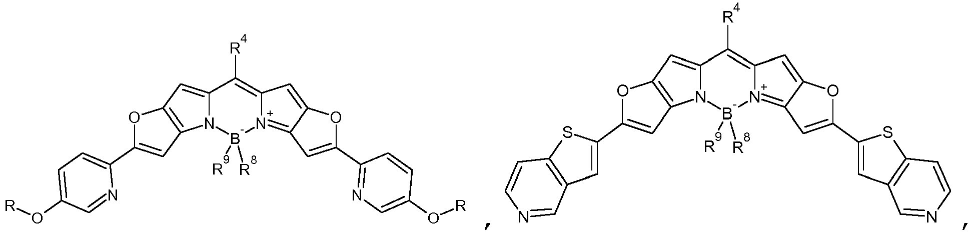

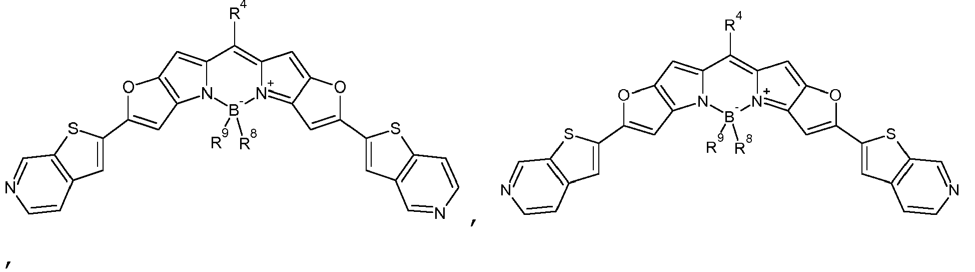

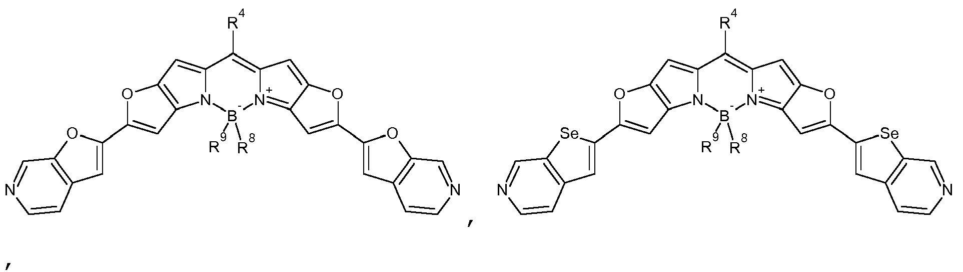

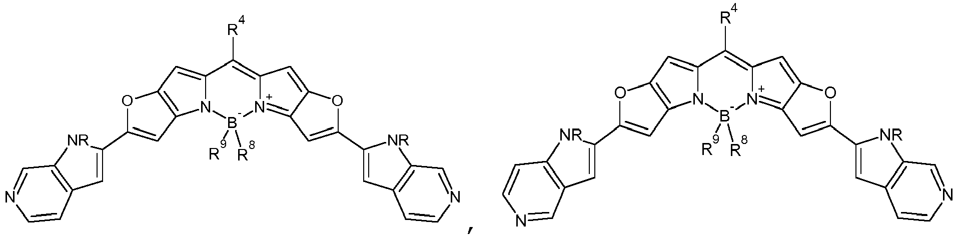

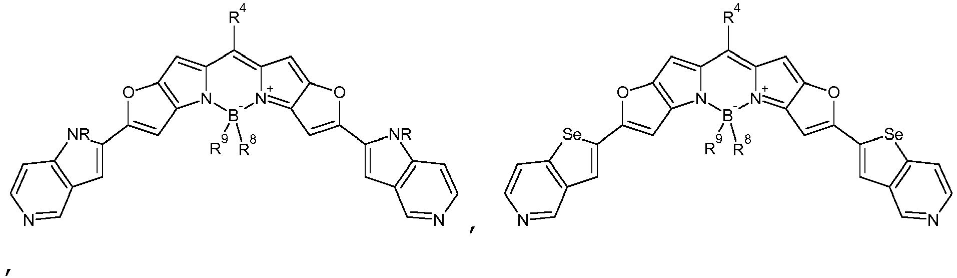

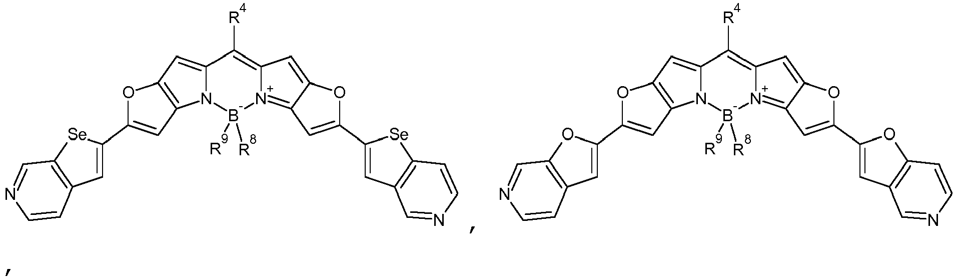

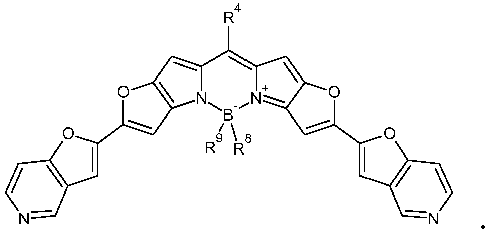

8. Solarzelle nach einem der vorhergehenden Ansprüche, wobei neben der zumindest einen Verbindung der allgemeinen Formel I oder II umfassenden Schicht zumindest eine Ladungsträgertransportschicht im Schichtstapel vorhanden ist, die dotiert, teilweise dotiert oder undotiert ist.

9. Solarzelle nach einem der vorhergehenden Ansprüche, wobei die Licht absorbierende Schicht als Mischschicht aus mindestens zwei unterschiedlichen Verbindungen mit oder ohne zusätzliche angrenzende Einzelschicht oder als Doppelmischschicht oder als Dreifachmischsicht ausgestaltet ist, bevorzugt ist die Mischschicht als bulk-heterojunction ausgeführt.

10. Solarzelle nach einem der vorhergehenden Ansprüche, wobei das Bauelement als Einzel-, Tandemzelle oder Mehrfachzelle ausgestaltet ist.

11. Solarzelle nach einem der vorhergehenden Ansprüche, wobei das Bauelement transparent ist oder teilweise transparent ist, wobei das Bauelement in dem für das menschliche Auge sichtbaren Spektralbereich transparent oder teilweise transparent ist.

12. Verwendung einer Verbindung der allgemeinen Formel I oder II gemäß der Ansprüche 1 bis 7 in der lichtabsorbierenden Schicht eines photoaktiven Bauelements, eines Photodetektors oder einer Einzel-, Tandem- oder Mehrfachsolarzelle, wobei die Verbindung der allgemeinen Formel I oder II ein Donor in einem Donor-Akzeptor-Übergang ist.

## Claims

1. Solar cell comprising a layer system wherein at least one layer of the layer system is a light absorbing layer, wherein said light absorbing layer comprises a compound of general formula I or II: 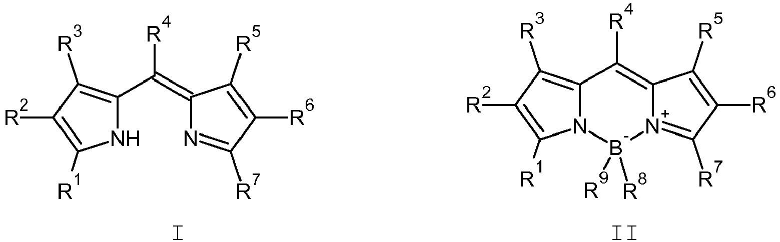 wherein
• R3, R4 and R5 are independently H or a radical selected from aryl, alkyl, fluorinated or partly fluorinated alkyl, unsaturated alkyl and
• R8 and R9 are independently selected from halogen, alkyl, fluorinated or partly fluorinated alkyl, alkenyl, alkynyl, alkoxy, aryl or heteroaryl
**characterized in that**
• R1 and R2, and R6 and R7 in each case together, form a heterocyclic 5-membered ring or 6-membered ring having at least one heteroatom selected from S, O, N and P, or R1 and R2, and R6 and R7 form a homocyclic 6-membered ring having no further fusion, wherein preferably, at least three of the four remaining bonding sites on the homocyclic ring remain unsubstituted and the compound of general formula I or II is a donor of an donor-acceptor-heteojunction.

2. Solar cell as claimed in claim 1, wherein the heterocyclic 5-member-ring formed by R1 and R2,and R6 and R7 is independently selected from one of following formulae 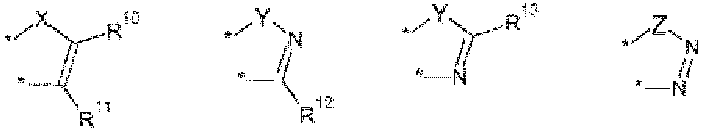 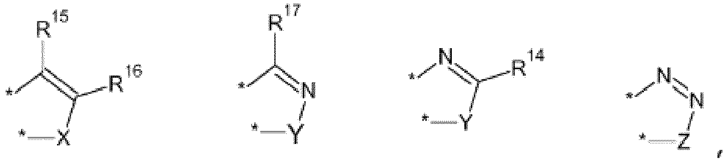 wherein
• the parts of the above formulae identified by * represent the bonding site to R1, R2, R6 or R7 of general formula I or II, and
• wherein X, Y and Z are each independently selected from O, S, Se or N-R18 with R18 selected from H and alkyl, and
• R10 to R17 are each independently selected from H, alkyl, alkynyl, alkenyl O-alkyl, s-alkyl, aryl, heteroaryl, halogenated alkyl, cyanated alkyl.

3. Solar cell as claimed in claim 1, wherein the homocyclic 6-member-ring formed by R1 and R2, and R6 and R7 and has no further fusion is selected from a compound of the following formula 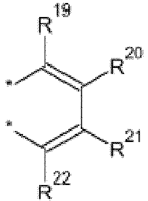 wherein
• the parts of the above formula identified by * represent the bonding site to R1, R2, R6 or R7 of general formula I or II, and
• R19 to R22 are each independently selected from H, alkyl, alkynyl, alkenyl O-alkyl, s-alkyl, aryl, heteroaryl, halogenated alkyl, cyanated alkyl.

4. Solar cell as claimed in claim 2 or 3, **characterized in that** the aryl or aryl radical at R10 to R17 or at R19 to R22 has a further radical increasing the donor character of the aryl or heteroaryl, preferably selected from alkyl, O-alkyl, N(alkyl)₂ or N-cycloalkyl.

5. Solar cell according to one of preceding claims, wherein radical R4 is selected from aryl, alkyl, fluorinated or partly fluorinated alkyl or unsaturated alkyl, preferably a fluorinated or partly fluorinated alkyl.

6. Solar cell according to one of the preceding claims, wherein the size of compound of the general formula I or II is between 300 and 1500 g/mol.

7. Solar cell according to one of the preceding claims, wherein the compound is selected from:

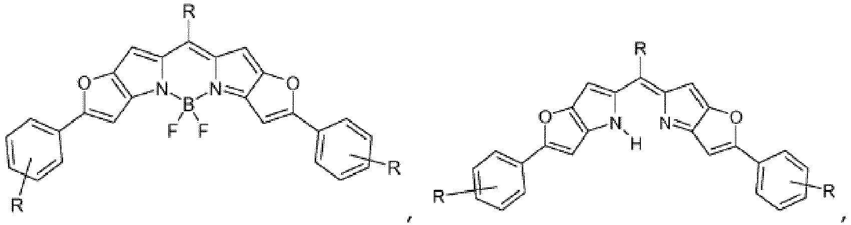

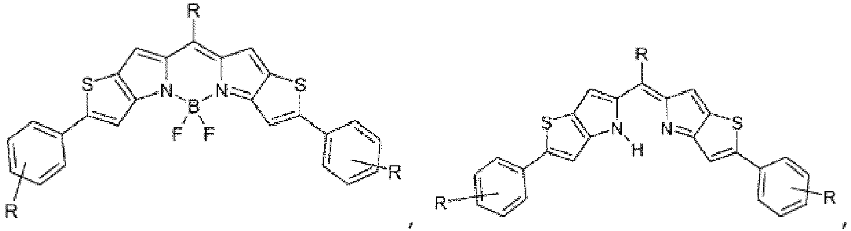

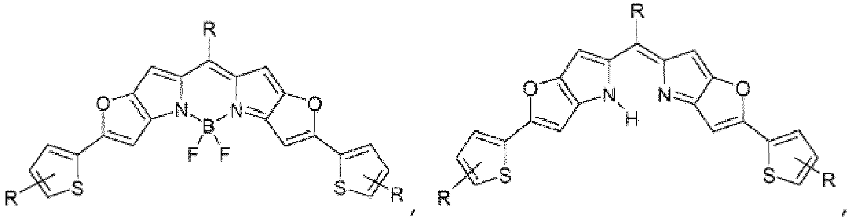

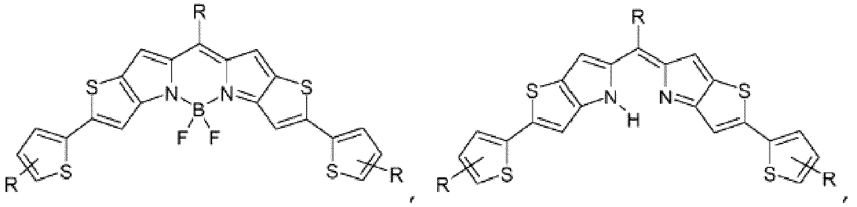

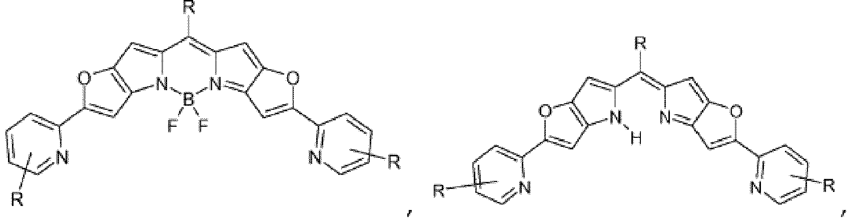

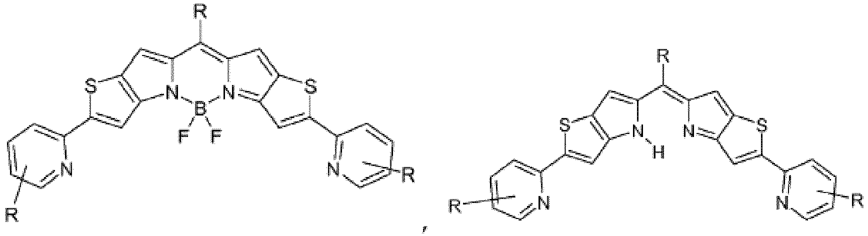

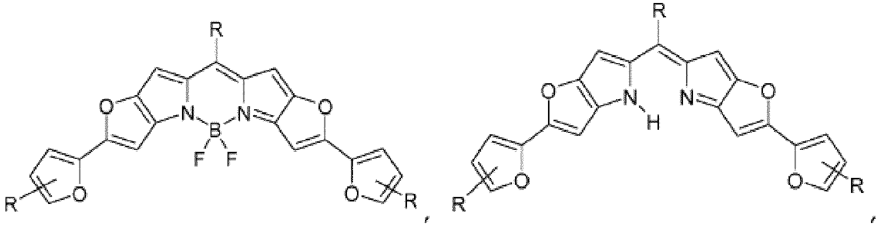

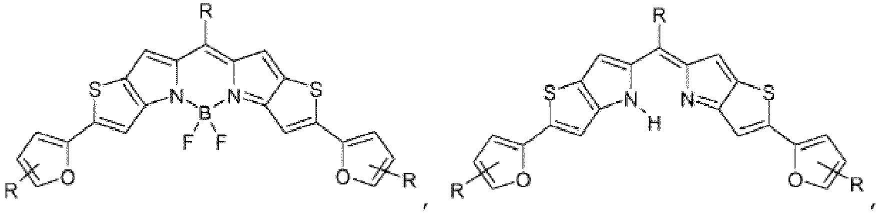

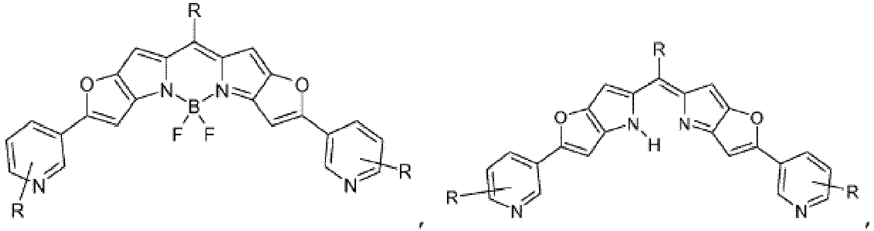

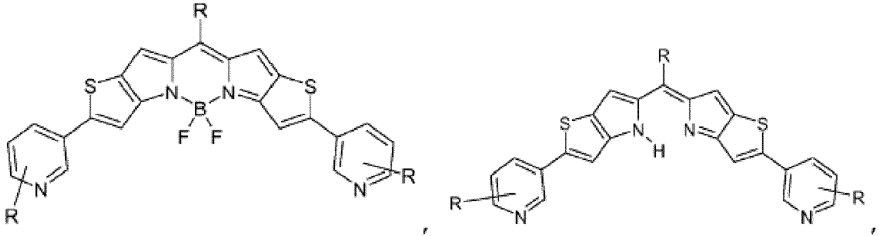

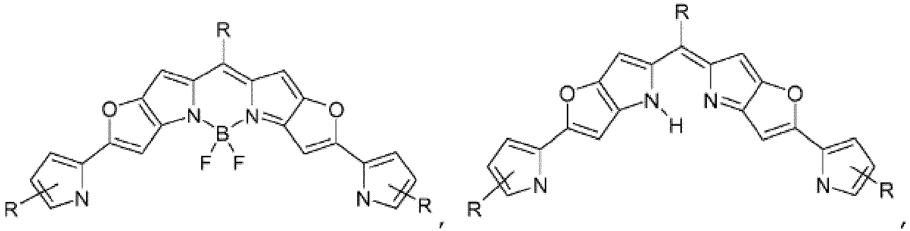

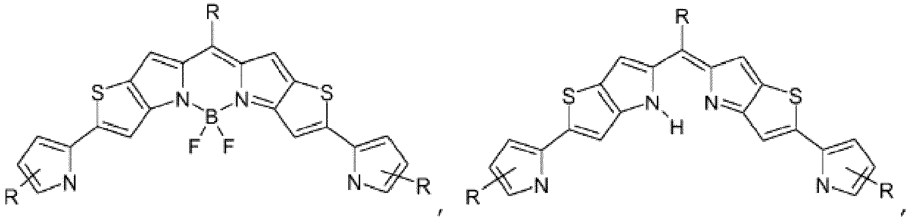

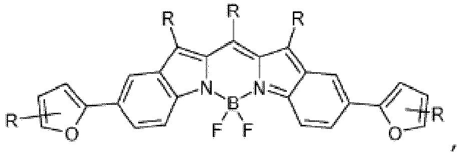

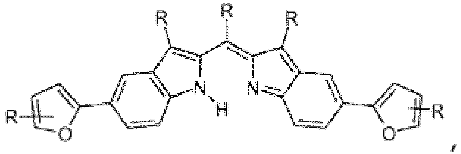

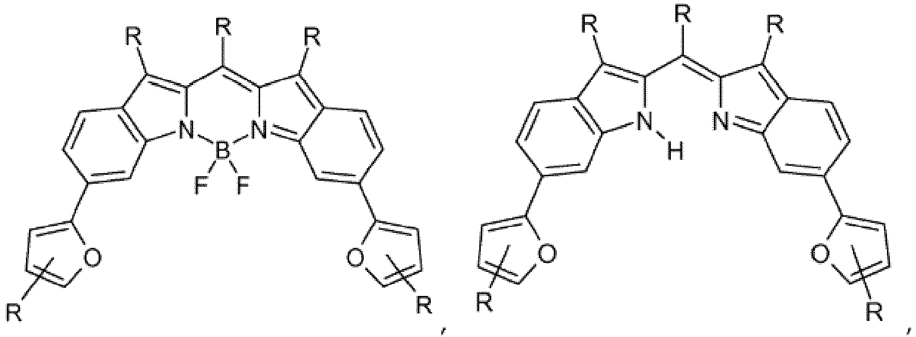

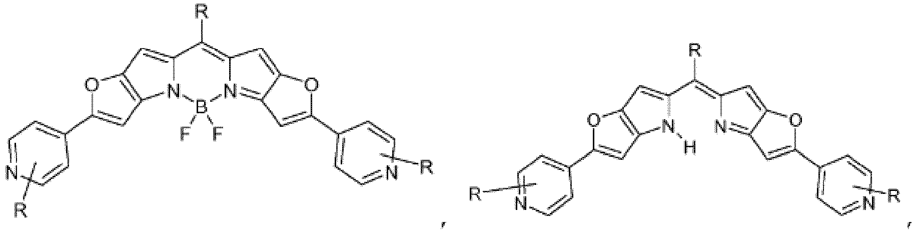

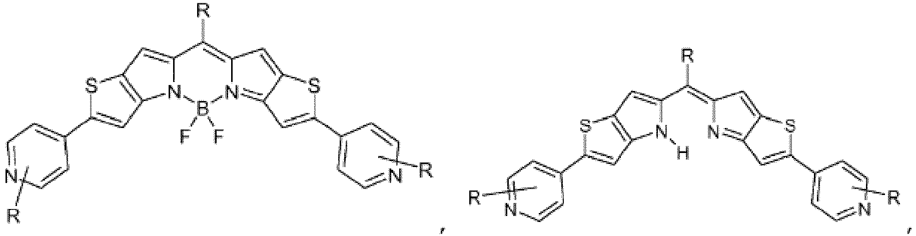

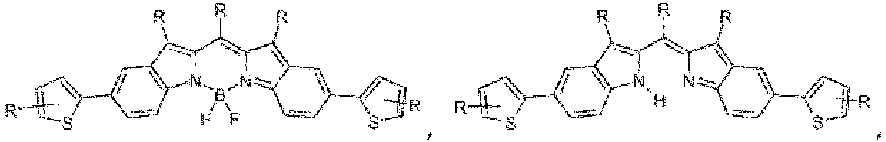

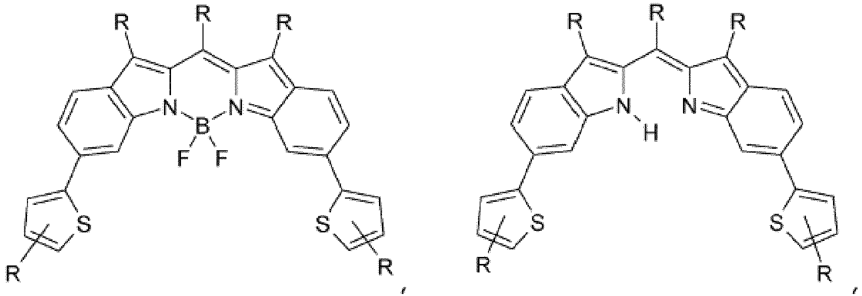

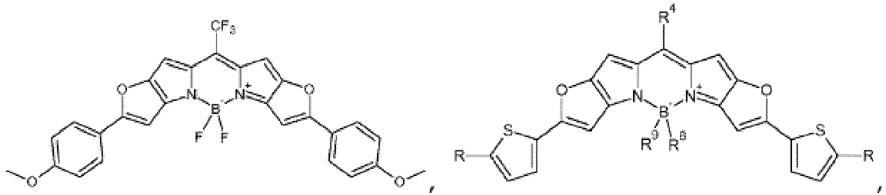

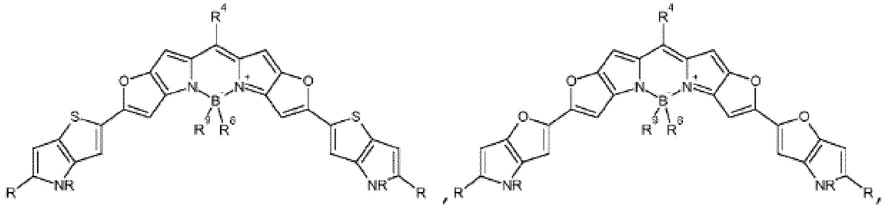

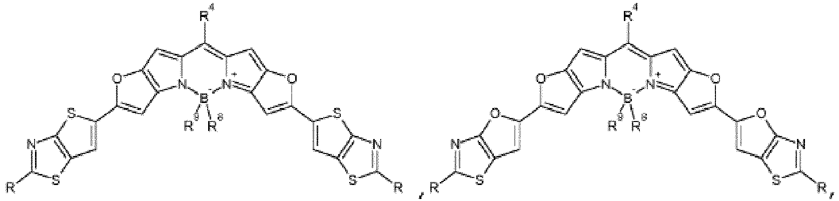

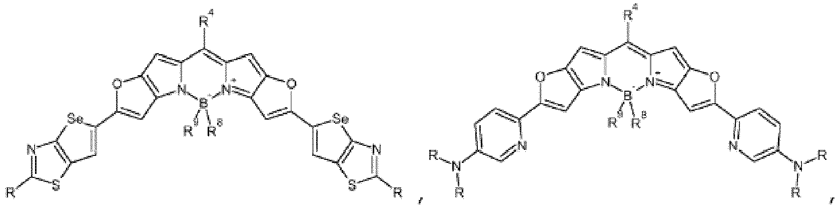

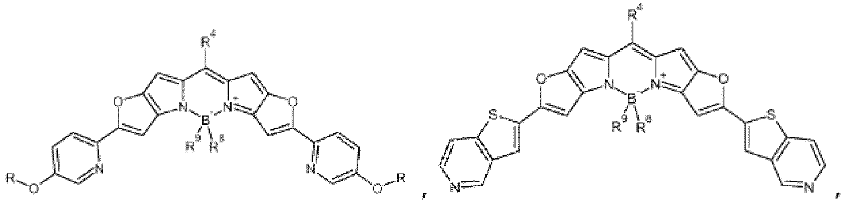

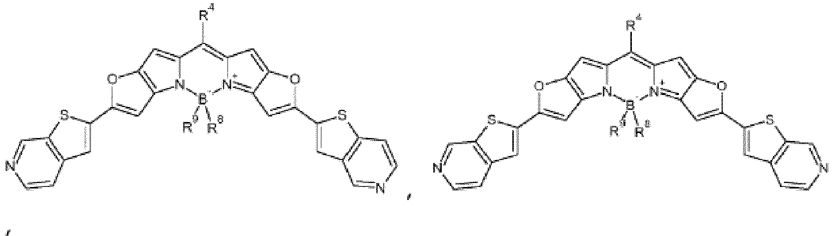

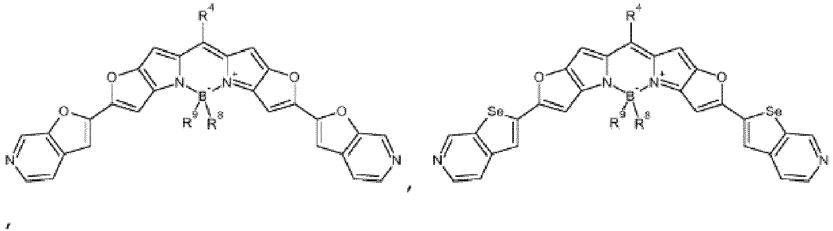

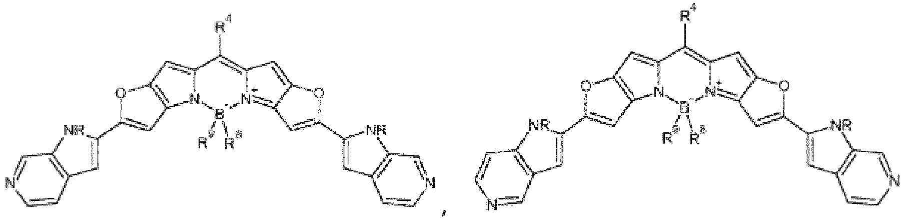

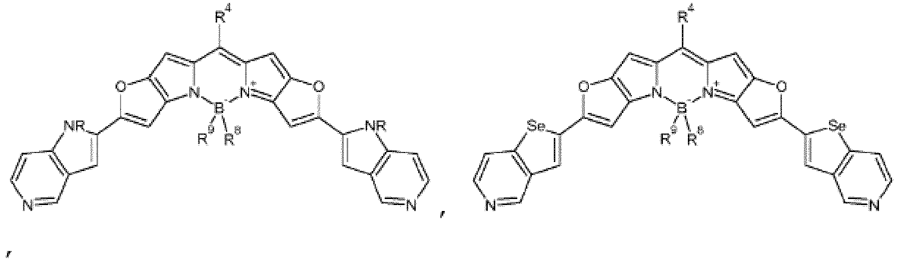

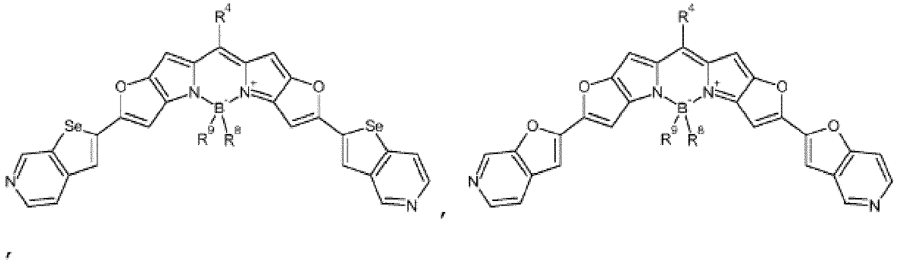

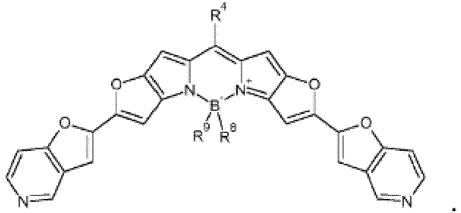

8. Solar cell according to one of the preceding claims, wherein in addition to the at least one compound of the general formula I or II comprising layer, at least one charge carrier transport layer is present in the layer system, which is doped, partially doped or undoped.

9. Solar cell according to one of preceding claims, wherein the light-absorbing layer is configured as a mixed layer composed of at least two different compounds with or without additional adjoining individual layer or as a double mixed layer or as a triple mixed layer, wherein said mixed layer is preferably a bulc-heterojunction.

10. Solar cell according to one of preceding claims, wherein the component is configured as a tandem cell or multiple cell.

11. Solar cell as claimed in one of preceding claims, wherein the component is transparent or partly transparent, wherein the component being transparent or partly transparent within a spectral range visible to the human eye.

12. Use of compound of general formula I or II according to one of claims 1 to 7 in a light absorbing layer of a photoactive component, a photodetector or a single, tandem or multiple solar cell, wherein the compound of general formula I or II is a donor in a donor-acceptor-heterojunction.

## Revendications

1. Cellule solaire comprenant un système de couche dans lequel au moins une couche du système de couche est une couche absorbant la lumière, dans laquelle ladite couche absorbant la lumière comprend un composé de formule générale I ou II: 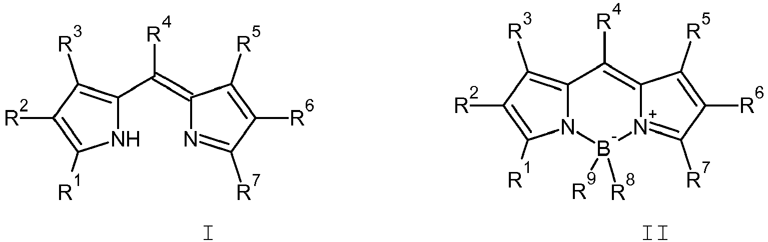 dans lesquels
• R3, R4 et R5 sont indépendamment H ou un radical choisi parmi aryle, alkyle, alkyle fluoré ou partiellement fluoré, alkyle insaturé, et
• R8 et R9 sont indépendamment choisis parmi halogène, alkyle, alkyle, alcényle, alcynyle, alcoxy, aryle ou hétéroaryle, fluoré ou partiellement fluoré
**caractérisé en ce que**
• R1 and R2, and R6 and R7 in each case together, form a heterocyclic 5-membered ring or 6-membered ring having at least one heteroatom selected from S, O, N and P, or R1 and R2, and R6 and R7 form a homocyclic 6-membered ring having no further fusion, wherein preferably, at least three of the four remaining bonding sites on the homocyclic ring remain unsubstituted and the compound of general formula I or II is a donor of an donor-acceptor-heteojunction.

2. Cellule solaire selon la revendication 1, dans laquelle le cycle hétérocyclique à 5 chaînons formé par R1 et R2, et R6 et R7 est indépendamment choisi parmi l'une des formules suivantes. 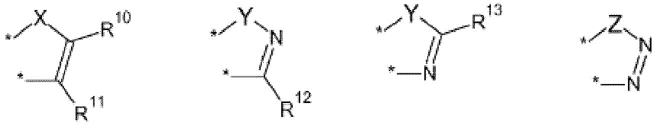 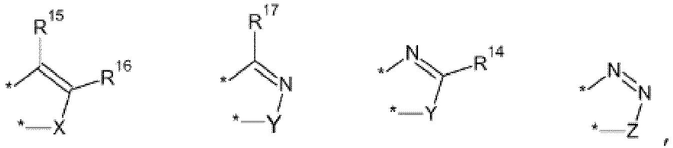 dans lequels
• les parties des formule ci-dessus identifiées par * représentent le site de liaison à R1, R2, R6 ou R7 de formules générales I ou II, et
• X, Y et Z sont chacun indépendamment choisis parmi O, S, Se ou N-R18 avec mit R18 choisi parmi H et alkyle, et
• R10 à R17 sont chacun indépendamment choisis parmi H, un alkyle, un alcynyle, un alcényle, un O-alkyle, un s-alkyle, un aryle, un hétéroaryle, un alkyle halogéné, un alkyle cyanaté.

3. Cellule solaire selon la revendication 1, dans laquelle le cycle homocyclique à 6 chaînons formé par R1 et R2, et R6 et R7 et ne subit aucune autre fusion est choisi parmi un composé de formule suivante 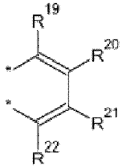 dans lequels
• les parties de la formule ci-dessus identifiées par * représentent le site de liaison à R1, R2, R6 ou R7 de formule générale I ou II, et
• R19 à R22 sont chacun indépendamment choisis parmi H, un alkyle, un alcynyle, un alcényle, un O-alkyle, un s-alkyle, un aryle, un hétéroaryle, un alkyle halogène, un alkyle cyanuré.

4. Cellule solaire selon la revendication 2 ou 3, **caractérisée en ce que** le radical aryle ou aryle en R10 à R17 ou en R19 à R22 a un radical supplémentaire augmentant le caractère donneur de l'aryle ou de l'hétéroaryle, de préférence, le radical supplémentaire est choisi parmi alkyle, O-alkyle, N(alkyle)₂ ou N-cycloalkyle.

5. Cellule solaire selon la revendication 1, dans laquelle le radical R4 est choisi parmi les groupes aryle, alkyle, alkyle fluoré ou partiellement fluoré ou alkyle insaturé, de préférence un alkyle fluoré ou partiellement fluoré.

6. Cellule solaire selon l'une des revendications précédentes, dans laquelle la taille du composé de formule générale I ou II est comprise entre 300 et 1500 g / mol.

7. Cellule solaire selon l'une des revendications précédentes, dans laquelle le composé est sélectionnée parmi:

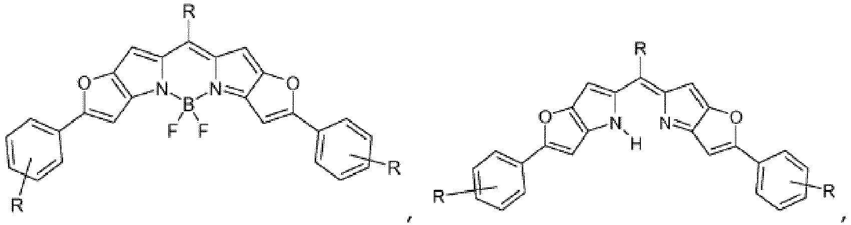

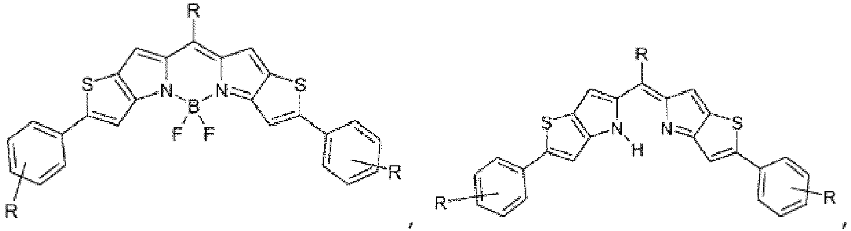

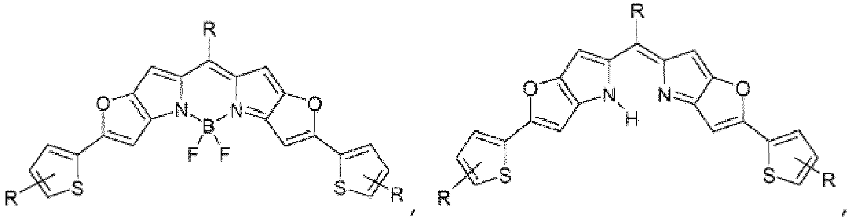

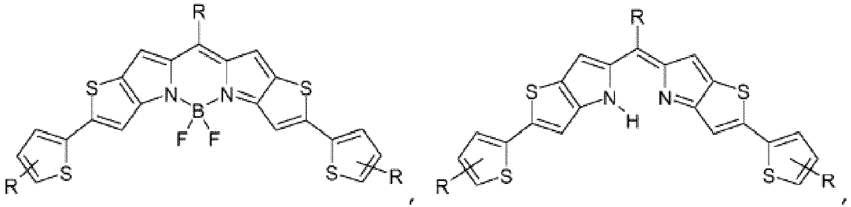

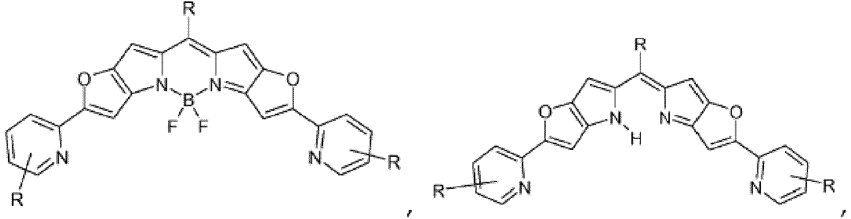

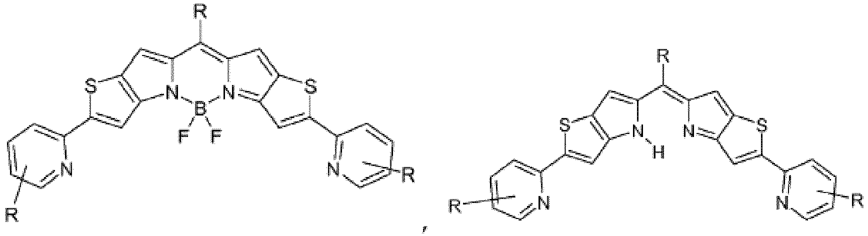

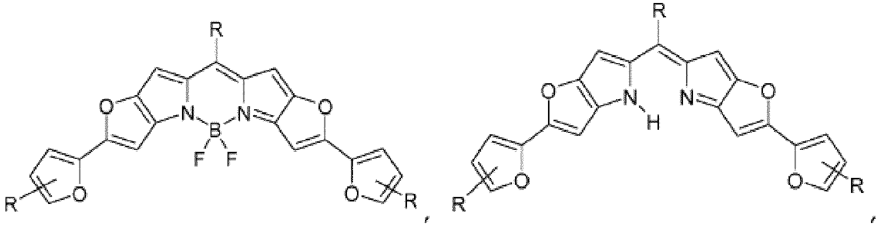

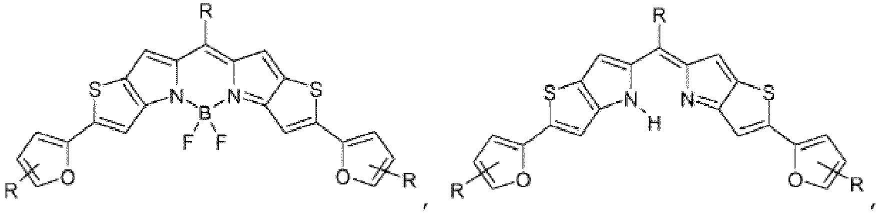

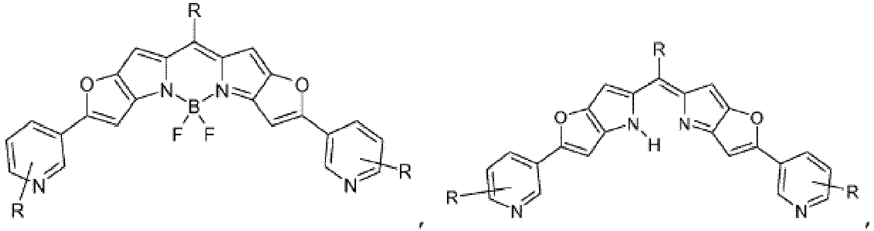

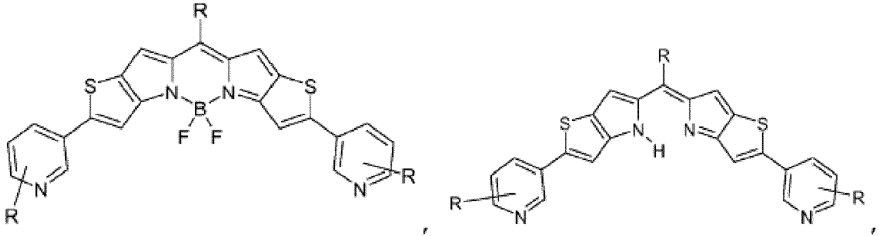

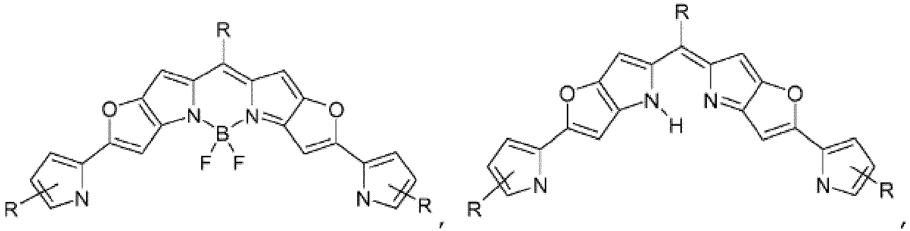

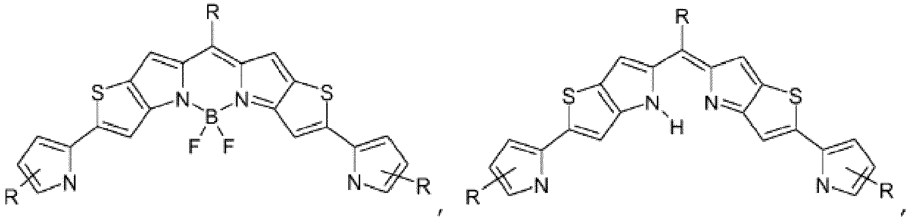

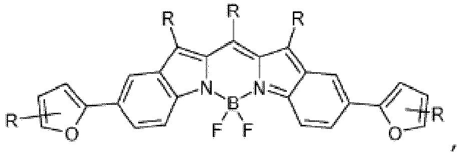

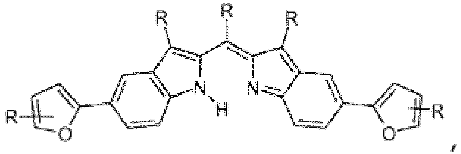

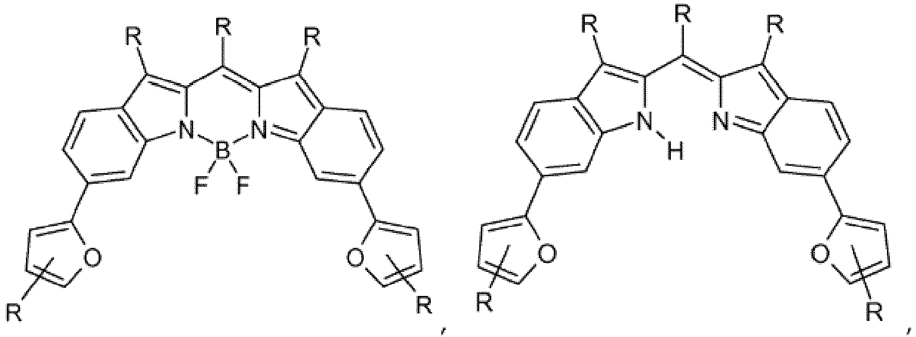

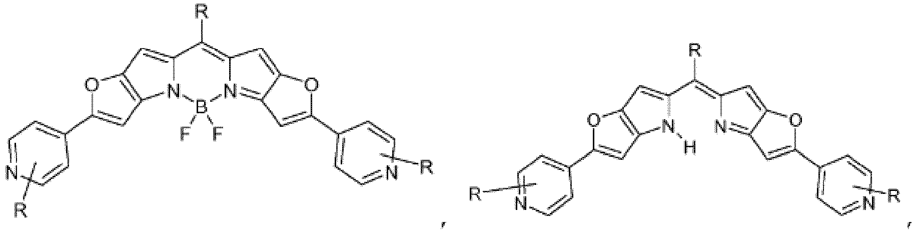

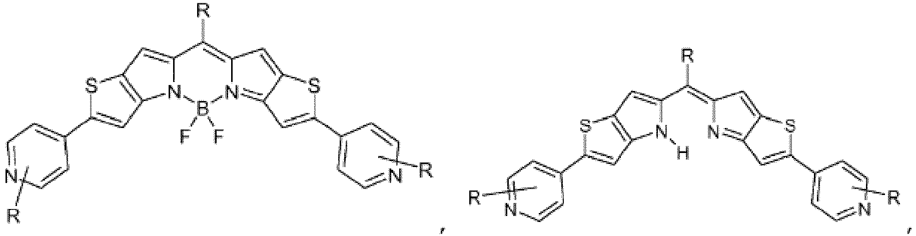

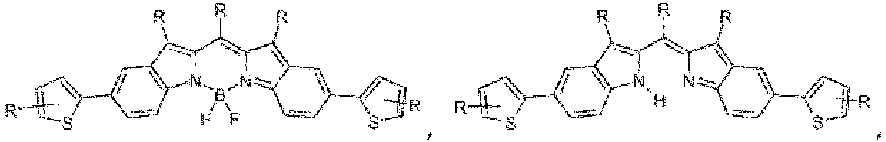

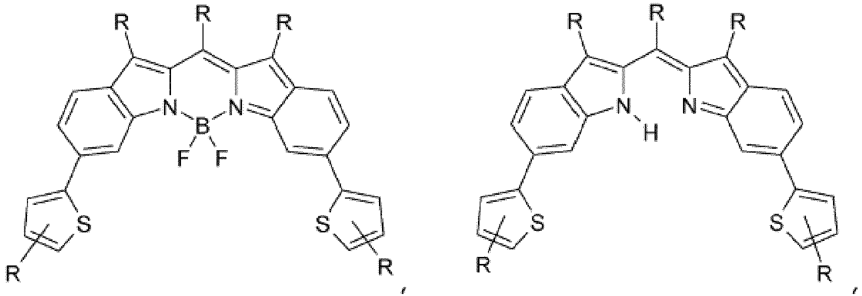

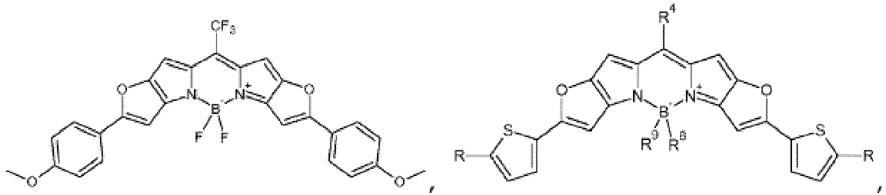

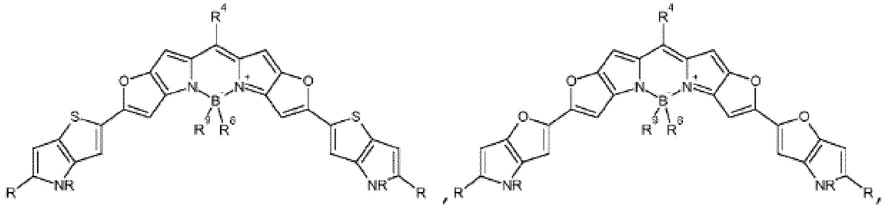

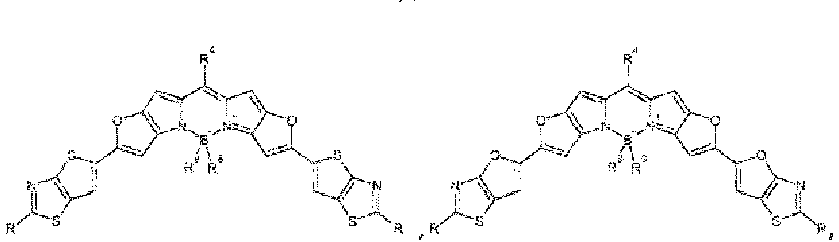

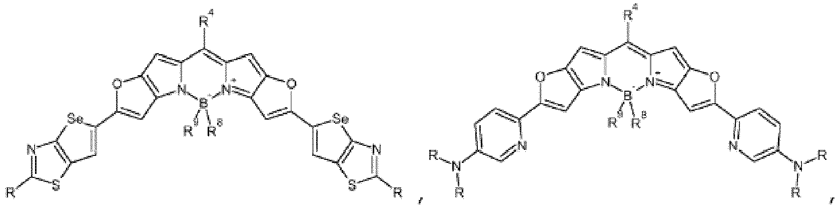

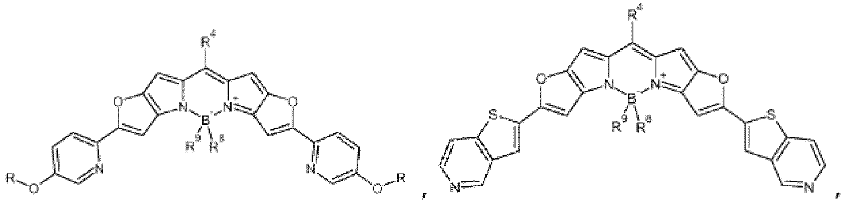

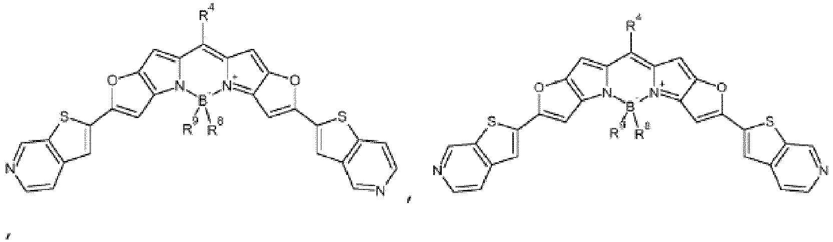

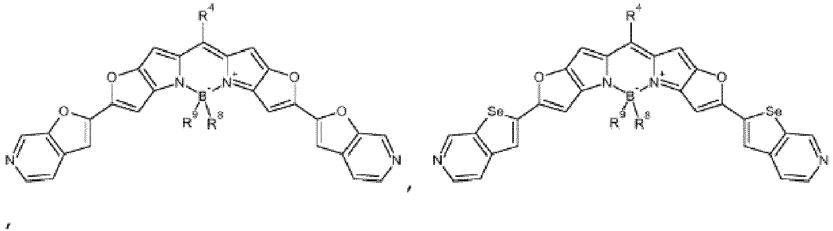

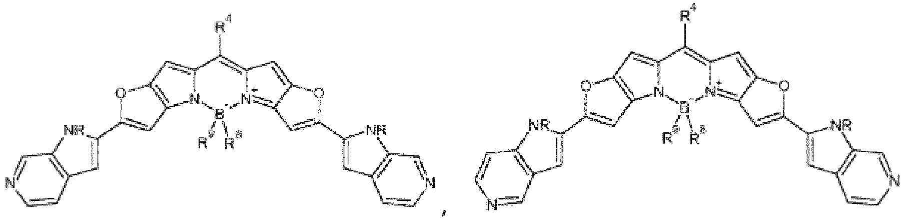

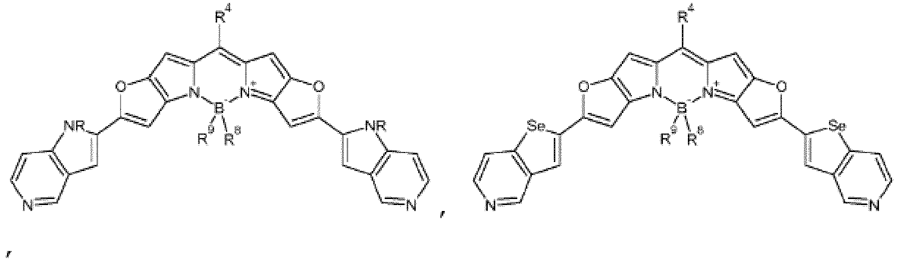

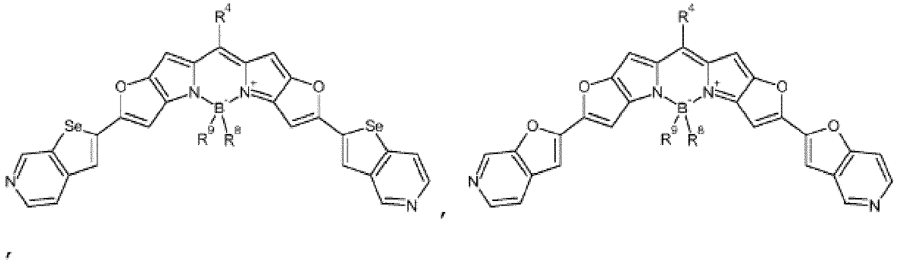

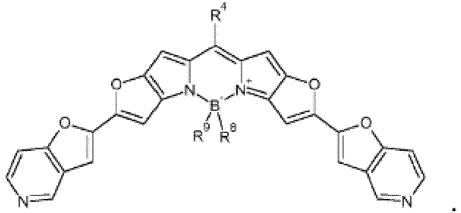

8. Cellule solaire selon l'une des revendications précédentes, dans laquelle en plus d'au moins un composé de formule générale I ou II comprenant une couche, au moins une couche de transport de porteurs de charges est présente dans l'empilement de couches, qui est dopé, partiellement dopé ou non dopé.

9. Cellule solaire selon l'une des revendications précédentes, dans laquelle la couche absorbant la lumière est conçue comme une couche mélangée composée d'au moins deux composés différents avec ou sans couche individuelle adjacente supplémentaire, ou comme une double couche mélangée ou comme une triple couche mélangée, dans laquelle ladite couche mixte est de préférence une bulc-hétérojonction.

10. Cellule solaire selon l'une des revendications précédentes, dans laquelle le composant est configuré en tant que cellule tandem ou cellule multiple.

11. Cellule solaire selon l'une des revendications précédentes, dans laquelle le composant est transparent ou partiellement transparent, le composant étant transparent ou partiellement transparent dans une plage spectrale visible à l'oeil humain.

12. Utilisation d'un composé de formule générale I ou II selon l'une des revendications 1 à 7 dans une couche absorbant la lumière d'un composant photoactif, d'un photodétecteur ou d'une cellule solaire simple, tandem ou multiple, dans laquelle le composé de formule générale I ou II est donneur dans une hétérojonction donneur-accepteur.
